# EUROPEAN PATENT SPECIFICATION

(11) **EP 1 762 894 B1**
(45) Date of publication and mention of the grant of the patent: **09.01.2013**
(21) Application number: 06017970.2
(22) Date of filing: 29.08.2006
(51) Int. Cl.: G03F 7/09, G03F 7/033

(54) **Photopolymerizable photosensitive lithographic printing plate**
Fotopolymerisierbare lichtempfindliche Lithografiedruckplatte
Plaque d'impression lithographique photosensible photopolymérisable

(30) Priority: 30.08.2005 JP 2005250048
(43) Date of publication of application: 14.03.2007
(73) Proprietor: FUJIFILM Corporation, Minato-ku Tokyo (JP)
(72) Inventor: Sakata, Kaku, Yoshida-cho Haibara-gun Shizuoka (JP)
(74) Representative: HOFFMANN EITLE

(56) References cited:
- EP-A- 1 341 040
- EP-A- 1 564 589
- EP-A- 1 693 706
- EP-A- 1 703 324

## Description

### Background of the Invention

### 1. Field of the Invention

The present invention relates to a photosensitive lithographic printing plate, in particular, relates to a photosensitive lithographic printing plate suitable for imaging with laser beams, and suitable for highly precise AM screen printing of screen line number of 200 lines or more and FM screen printing.

### 2. Description of the Related Art

A lithographic printing plate has been conventionally obtained by a plate-making method of generally subjecting a photosensitive lithographic printing plate comprising a hydrophilic support having provided thereon a photosensitive resin layer to areal exposure (mask exposure) through a lith film, and removing a non-image area in a developing solution. However, with the digitized techniques in recent years, computer-to-plate (CTP) techniques of performing exposure treatment directly on a printing plate by scanning the printing plate according to digitized image data with high convergent light such as laser beams without using a lith film has been developed, and photosensitive lithographic printing plates suitable for such techniques are developed.

As such a photosensitive lithographic printing plate suitable for exposure with laser beams, a photosensitive lithographic printing plate using a polymerizable photosensitive layer can be exemplified. This is for the reason that the increase in sensitivity of a polymerizable photosensitive layer is easy by the selection of a photopolymerization initiator or a polymerization initiator (hereinafter sometimes referred to as merely an initiator) as compared with other conventional photosensitive layers.

However, since such a photosensitive lithographic printing plate is imaged with laser beams, the edge of an image is dependent upon the form of energy distribution of the laser beams, so that an area insufficient in polymerization resulting from insufficient exposure is liable to be formed. Therefore, the sharpness at the edge of the image is impaired and results in the reduction of resolution. Further, such an image edge insufficient in polymerization causes removal failure due to the alkali concentration of a developing solution and the state of a development brushing in a developing treatment process, so that the dot area of the resulting printing plate generates large in-plane unevenness.

In addition, since a support having surface unevenness formed by electrolytic treatment or brushing treatment is used in such a printing plate for retaining a hydrophilic property, image quality and sharpness are further impaired by scattering of the reflected light at the time of laser exposure, and the reproducibility at a shadow part greatly lowers.

On the other hand, in recent years, the requirement for highly precise AM screen printing and FM screen printing has increased in the CTP techniques, so that the resolution of a photosensitive lithographic printing plate precursor is an important performance.

FM (Frequency Modulation) screen is a screen that arranges minute dots of 20 µm or so at random irrespective of screen angle and line number to express the gradation of density by the dot density per a unit area. The printed matters by FM screen are characterized in that interference moiré and rosette pattern do not occur, tone jump at half tone in the vicinity of 50% does not occur, and, since dots are minute, overlapping of the dots with each other lessens, so that reproduced color looks sharp.

Contrary to FM screen, a screen that regularly arranges dots with a certain angle to express the gradation of density by the dot size per a unit area is called AM (Amplitude Modulation) screen. The line number of AM screen in Japan is ordinarily 175 lines per inch. In contrast to this, the screen using screen lines of 200 or more is generally called highly precise AM screen.

As the characteristics of highly precise printed matters, the decrease of moiré and rosette pattern, the improvements of the texture of image, a feeling of presence, and the reproduction of details are exemplified.

However, photosensitive materials such as the above lithographic printing plate precursor using a polymerizable photosensitive layer lowering in the reproducibility at a shadow part cannot reproduce extremely minute dots, so that these materials are difficult to be used as the materials to provide a printing plate suitable for FM screen printing and highly precise AM screen printing.

JP-A-2003-43703 (the term "JP-A" as used herein refers to an "unexamined published Japanese patent application") discloses a photosensitive lithographic printing plate comprising a support having thereon an interlayer containing a polymer compound having a constitutional unit having a sulfonic acid group at the side chain, and provided a polymerizable photosensitive layer thereon, but this lithographic printing plate is not yet satisfactory as the printing plate suitable for highly precise AM screen printing and FM screen printing, in particular irregularity of plain dots in FM screen is great, therefore, it is difficult to use FM screen, in addition, preservation stability is also not sufficient.

EP-A-1 693 706 and EP-A-1 703 324, both prior art pursuant to Article 54(3) EPC, disclose photosensitive lithographic printing plates comprising, in order, a hydrophilic support, a photopolymerizable photosensitive layer and a protective layer. Their respective photopolymerizable photosensitive layers comprise in turn a sensitising dye, a photopolymerization initiator, an addition polymerizable compound having an ethylenic unsaturated double bond and a binder polymer.

EP-A-1 341 040 discloses a negative type photopolymerizable photosensitive lithographic printing plate comprising a hydrophilic support, a photopolymerizable photosensitive layer and a protective layer comprising a polyvinyl alcohol with a saponification degree of 98 mol.%. The photosensitive layer comprises a sensitising dye, a photopolymerization initiator, an addition polymerizable compound having an ethylenic unsaturated double bond, and a binder polymer.

EP-A-1 564 589 discloses a photosensitive lithographic printing plate precursor comprising a support and at least one photopolymerizable layer for imaging by scanning with a laser beam. This layer comprises a sensitising dye, a polymerisation initiator, an addition polymerizable compound having an ethylenically unsaturated double bond and a binder polymer.

### Summary of the Intention

An object of the invention is to provide a lithographic printing plate suitable for imaging with laser beams, good in preservation stability, and good in half tone plain dot uniformity using highly precise AM screen printing of screen line number of 200 lines or more and FM screen printing, in particular, FM screen.

As a result of eager examination, the present inventors have achieved the above object by the following constitutions.
(1) A negative type photopolymerizable photosensitive lithographic printing plate, which is capable of image-recording with laser beams, comprising, in order:
   a hydrophilic support;
   at least one photopolymerizable photosensitive layer; and
   a protective layer comprising a water-soluble polymer containing a polyvinyl alcohol having a saponification degree of 95 mol% or more, and a water-soluble polymer containing sulfonic acid groups or an alkali metal salt or an ammonium salt of sulfonic acid groups,
   wherein the at least one photosensitive layer comprises:
      (i) a sensitizing dye having an absorption maximum in a wavelength region of from 360 to 450 nm;
      (ii) a photopolymerization initiator;
      (iii) an addition polymerizable compound having an ethylenic unsaturated double bond; and
      (iv) a binder polymer that comprises at least one repeating unit represented by formula (1): 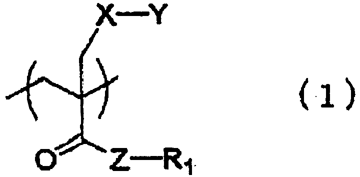 wherein X represent an oxygen atom, a sulfur atom or an -NH- group;
         Y represents a hydrogen atom or a hydrocarbon group having from 1 to 20 carbon atoms which may have a substituent;
         Z represents an oxygen atom, a sulfur atom or an -NH-group; and
         R₁ represents a hydrocarbon group having from 1 to 20 carbon atoms which may have a substituent.
(2) The negative type photopolymerizable photosensitive lithographic printing plate as described in (1) above,
   wherein (ii) the photopolymerization initiator is a hexaarylbisimidazole compound.
(3) The negative type photopolymerizable photosensitive lithographic printing plate as described in (2) above,
   wherein (ii) the photopolymerization initiator further comprises a sulfur-containing compound represented by formula (2) or (3) : 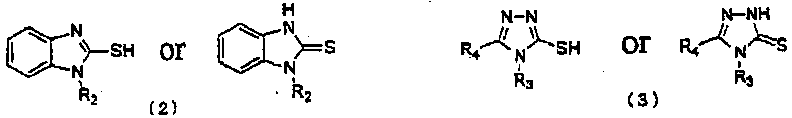 wherein R₂, R₃ and R₄ each independently represents a hydrogen atom, a straight chain or branched alkyl group having from 1 to 18 carbon atoms which may have a substituent, an alicyclic alkyl group having from 5 to 20 carbon atoms or an aromatic group.
(4) The negative type photopolymerizable photosensitive lithographic printing plate as described in any of (1) to (3) above,
   wherein the sensitizing dye is a dye represented by formula (4), (5), (6) or (7) : 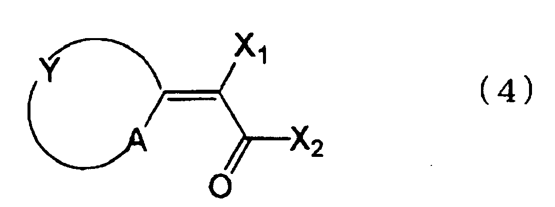 wherein
   A represents a sulfur atom or NR₆;
   R₆ represents a monovalent nonmetallic atomic group;
   Y represents a nonmetallic atomic group to form a basic nucleus of the dye conjointly with the contiguous A and the contiguous carbon atom; and
   X₁ and X₂ each independently represents a monovalent nonmetallic atomic group, and X₁ and X₂ may be bonded to each other to form an acidic nucleus of the dye, 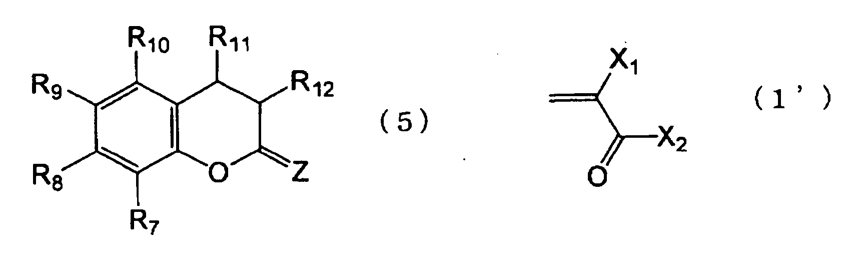
   wherein =
   Z represents a carbonyl group, a thiocarbonyl group, an imino group or an alkylidene group represented by partial structural formula (1');
   X₁ and X₂ have the same meaning as in formula (4); and
   R₇ to R₁₂ each independently represents a monovalent nonmetallic atomic group, 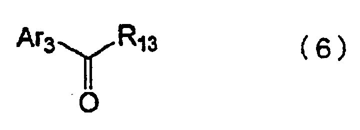
   wherein
   Ar₃ represents an aromatic group or a heteroaromatic group, each of which may have a substituent; and
   R₁₃ represents a monovalent nonmetallic atomic group, or 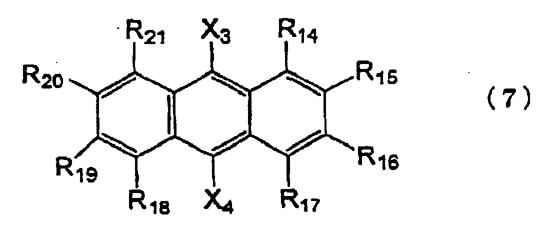 wherein X₃, X₄, R₁₄ to R₂₁ each independently represents a monovalent nonmetallic atomic group.
(5) The negative type photopolymerizable photosensitive lithographic printing plate as described in (4) above,
   wherein the sensitizing dye is a dye represented by formula (8): 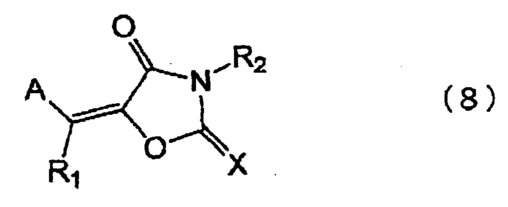 wherein
   A represents an aromatic ring or a heterocyclic ring that may have a substituent;
   X represents an oxygen atom, a sulfur atom or NR₃;
   R₁, R₂ and R₃ each independently represents a hydrogen atom or a monovalent nonmetallic atomic group, and A and R₁, and R₂ and R₃ may be bonded to each other to form an aliphatic or aromatic ring.
(6) The negative type photopolymerizable photosensitive lithographic printing plate as described in any of (1) to (5) above,
   wherein the binder polymer further comprises: (a) a repeating unit for imparting alkali solubility; and (b) a repeating unit for imparting a radical crosslinking property.

### Detailed Description of the Invention

### Photopolymerizable Photosensitive Lithographic Printing Plate:

With respect to a photopolymerizable photosensitive lithographic printing plate (a lithographic printing plate precursor) having spectral sensitivity in a wavelength region of from 360 to 450 nm for use in the invention, the constituents are described in order below.

### Support:

Supports for use in a photopolymerizable photosensitive lithographic printing plate are described in the first place.

Any supports can be used in the invention so long as they have a hydrophilic surface, but plate-like supports having dimensional stability are preferably used. For example, paper, paper laminated with plastics (e.g., polyethylene, polypropylene, polystyrene, etc.), plates of metals, e.g., aluminum (including aluminum alloys), zinc, copper, and alloys of metals (e.g. , alloys with silicon, copper, manganese, magnesium, chromium, zinc, lead, bismuth, or nickel), plastic films, e.g., cellulose diacetate, cellulose triacetate, cellulose propionate, cellulose butyrate, cellulose butyrate acetate, cellulose nitrate, polyethylene terephthalate, polyethylene, polystyrene, polypropylene, polycarbonate, polyvinyl acetal, etc., and paper or plastic films laminated or deposited with the above metals or alloys can be exemplified. Of these supports, aluminum plates, which are dimensionally very stable and inexpensive, are especially preferred. Further, composite sheets comprising a polyethylene terephthalate film having bound thereon an aluminum sheet as disclosed in JP-B-48-18327 are also preferred. The thickness of these sheets is generally from 0.05 to 1 mm or so.

In the case of supports having a metal surface, in particular an aluminum surface, it is preferred that the supports are surface-treated by the later-described graining treatment, immersion treatment in an aqueous solution of sodium silicate, potassium fluorozirconate, or phosphate, or anodizing treatment.

As the graining treatments, there are mechanical graining, chemical etching, and electrolytic graining as disclosed in JP-A-56-28893. An electrochemical graining method of electrochemical graining in a hydrochloric acid or nitric acid electrolyte, and mechanical graining methods, e.g., a wire brush graining method of scratching an aluminum surface with metal wire, a ball graining method of graining an aluminum surface with abrading balls and abrasives, and a brush graining method of graining an aluminum surface with nylon brushes and abrasives can be used. These graining methods can be used alone or in combination.

Of these methods, a surface roughening method usefully used in the invention is the electrochemical surface roughening method of electrochemical graining in a hydrochloric acid or nitric acid electrolyte, and preferred electric current density is from 100 to 400 C/dm². Further specifically, it is preferred to perform electrolysis in an electrolyte containing from 0.1 to 50 mass% of a hydrochloric acid or a nitric acid on conditions of from 20 to 100°C for 1 second to 30 minutes at electric current density of from 100 to 400 C/dm². (In this specification, mass ratio is equal to weight ratio.)

The thus-surface grained aluminum support is then subjected to chemical etching with an acid or an alkali. When acids are used as the etchants, it takes time to break down minute structures, so that industrially disadvantageous to be applied to the invention, but this point can be improved by the use of alkalis as the etchants.

As the alkali agents preferably used in the invention, sodium hydroxide, sodium carbonate, sodium aluminate, sodium metasilicate, sodium phosphate, potassium hydroxide, and lithium hydroxide are exemplified, and the preferred ranges of concentration and temperature are from 1 to 50 mass% and from 20 to 100°C, respectively, and conditions of making the dissolving amount of aluminum of from 5 to 20 g/m² are preferred.

For the removal of residual smuts on the surface after etching, acid cleaning is performed. As the acids for use in cleaning, e.g., a nitric acid, a sulfuric acid, a phosphoric acid, a chromic acid, a fluoric acid, and a borofluoric acid can be exemplified. In particular, as preferred smut-removing treatment methods after electrochemical surface roughening treatment, a method of bringing the aluminum support into contact with a 15 to 65 mass% sulfuric acid at 50 to 90°C as disclosed in JP-A-53-12739, and an alkali etching method as disclosed in JP-B-48-28123 are preferably exemplified.

Incidentally, the surface roughness (Ra) of an aluminum support in the invention is preferably from 0.3 to 0.7 µm.

The thus-treated aluminum support is further subjected to anodizing treatment.

Anodizing treatment can be carried out by the methods conventionally used in the technical field. Specifically, an anodic oxide film can be formed on the surface of an aluminum support by the application of direct or alternating current to an aluminum support in an aqueous or nonaqueous solution comprising a sulfuric acid, a phosphoric acid, a chromic acid, an oxalic acid, a sulfamic acid, or a benzenesulfonic acid, or combination of two or more of these acids.

The conditions of anodizing treatment broadly vary depending upon electrolytes to be used, so that cannot be determined unconditionally, but generally appropriately the concentration of an electrolyte is from 1 to 80%, liquid temperature is from 5 to 70°C, electric current density is from 0.5 to 60 A/dm², voltage is from 1 to 100 V, and electrolytic time is from 10 to 100 seconds.

Of anodizing treatments, a method of anodizing by high electric current density in a sulfuric acid as disclosed in British Patent 1, 412, 768, and a method of anodizing with a phosphoric acid as the electrolytic bath as disclosed in U.S. Patent 3,511,661 are especially preferred.

In the invention, an anodic oxide film is preferably from 1 to 10 g/m², when the film is less than 1 g/m², the resulting plate is liable to be scratched, and when it exceeds 10 g/m², much electric power is necessary in manufacture, so that economically disadvantageous. An anodic oxide film in the invention is preferably from 1.5 to 7 g/m², and more preferably from 2 to 5 g/m².

Further, in the invention, a support may be subjected to void-sealing treatment after graining and anodizing treatments. The void-sealing treatment is performed by the immersion of the support in a hydrothermal solution containing hot water and an inorganic salt or an organic salt, and water vapor bathing. A support for use in the invention may be subjected to treatment other than silicate treatment by alkali metal silicate, e.g., surface treatment by immersion in an aqueous solution of potassium fluorozirconate or phosphate.

In the invention, by coating on a support (in case of aluminum supports, aluminum supports subjected to arbitrary surface treatment as described above are preferred), e.g., a photopolymerizable photosensitive layer comprising a photopolymerizable photosensitive composition, and then a protective layer, a photopolymerizable photosensitive lithographic printing plate is formed, but if necessary, an organic or inorganic undercoat layer may be coated before coating the photopolymerizable photosensitive layer, or a support may be treated with sol-gel treatment of covalent bonding a functional group capable of causing addition reaction by radicals as disclosed in JP-A-7-159983.

As the materials for forming an organic undercoat layer, water-soluble resins, e.g., polyvinylphosphonic acid, polymers and copolymers having a sulfonic acid group on the side chain, polyacrylic acid, carboxymethyl cellulose, dextrin, gum arabic, low molecular weight organic compounds, e.g., phosphonic acids having an amino group such as 2-aminoethylphosphonic acid, organic phosphonic acids that may have a substituent such as phenylphosphonic acid, naphthylphosphonic acid, alkylphosphonic acid, glycero- phosphonic acid, methylenediphosphonic acid, ethylene- diphosphonic acid, etc., organic phosphoric acids that may have a substituent such as phenylphosphoric acid, naphthylphosphoric acid, alkylphosphoric acid, glycerophosphoric acid, etc., organic phosphinic acids that may have a substituent such as phenylphosphinic acid, naphthylphosphinic acid, alkylphosphinic acid, glycerophosphinic acid, etc., amino acids such as glycine, β-alanine, etc., amine hydrochloride having a hydroxyl group such as triethanolamine hydrochloride, etc., water-soluble metallic salt (e.g., zinc borate), yellow dyes, amine salts, etc., are exemplified. These compounds may be used as mixtures of two or more kinds.

The organic undercoat layer can be formed by the methods as follows. That is, a method of dissolving the above organic compounds in water or an organic solvent, e.g., methanol, ethanol, methyl ethyl ketone, etc., or a mixed solvent of these organic solvents to prepare a coating solution, coating the coating solution on a support, and then drying to thereby form an organic undercoat layer, and a method of dissolving the above organic compounds in water or an organic solvent, e. g. , methanol, ethanol, methyl ethyl ketone, etc., or a mixed solvent of these organic solvents to prepare a solution, immersing a support in the obtained solution to adsorb the organic compounds onto the support, and then washing with water and drying the support to form an organic undercoat layer are exemplified. In the former method, the solution of the organic compounds in concentration of from 0.005 to 10 mass% can be coated by various methods. For example, any of bar coating, rotary coating, spray coating and curtain coating can be used. In the latter method, the concentration of the solution is from 0.01 to 20 mass%, preferably from 0.05 to 5 mass%, the immersion temperature is from 20 to 90°C, preferably from 25 to 50°C, the immersion time is from 0.1 seconds to 20 minutes, and preferably from 2 seconds to 1 minute.

The solution for an undercoat layer can also be used at pH range of from 1 to 12 by adjusting pH with basic materials, e.g., ammonia, triethylamine, potassium hydroxide, etc., and acidic materials, e.g., hydrochloric acid, phosphoric acid, etc. It is also possible to add yellow dyes for the purpose of improving the tone reproducibility of a photopolymerizable photosensitive lithographic printing plate.

Dry coating amount of an organic undercoat layer is from 2 to 200 mg/m², and preferably from 5 to 100 mg/m². When the dry coating amount is less than 2 mg/m², sufficient press life cannot be obtained, and this is also the same when the dry coating amount is more than 200 mg/m².

As the materials for use in an inorganic undercoat layer, inorganic salts, e.g., cobalt acetate, nickel acetate, potassium titanate fluoride, etc., and coating methods of the inorganic undercoat layer are the same as in the organic undercoat layer described above.

### Photosensitive Layer:

### Sensitizing dye:

The sensitizing dyes for use in a photo- polymerizable photosensitive lithographic printing plate in the invention are sensitizing dyes having absorption maximum in the wavelength region of from 360 to 450 nm. As such sensitizing dyes, e.g., merocyanine dyes represented by the following formula (4), benzopyrans and coumarins represented by the following formula (5), aromatic ketones represented by the following formula (6), and anthracenes represented by the following formula (7) can be exemplified.

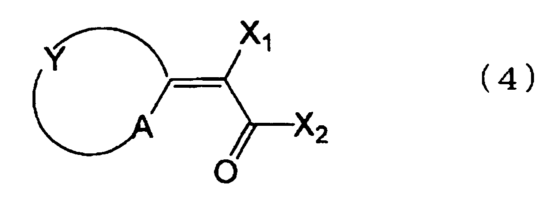

In formula (4), A represents a sulfur atom or NR₆; R₆ represents a monovalent nonmetallic atomic group; Y represents a nonmetallic atomic group to form the basic nucleus of the dye conjointly with the contiguous A and the contiguous carbon atom; and X₁ and X₂ each represents a monovalent nonmetallic atomic group, and X₁ and X₂ may be bonded to each other to form an acidic nucleus of the dye.

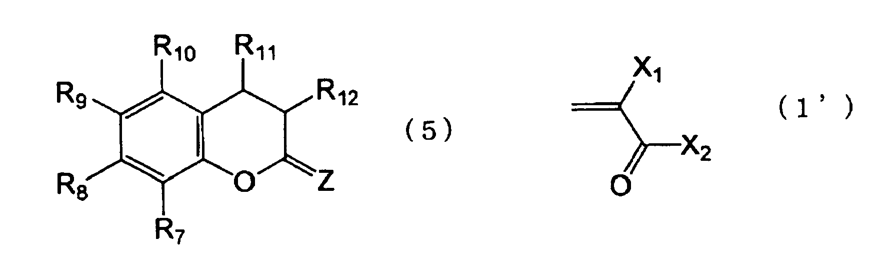

In formula (5), =Z represents a carbonyl group, a thiocarbonyl group, an imino group, or an alkylidene group represented by the above partial structural formula (1'); X₁ and X₂ have the same meaning as in formula (4); and R₇ to R₁₂ each represents a monovalent nonmetallic atomic group.

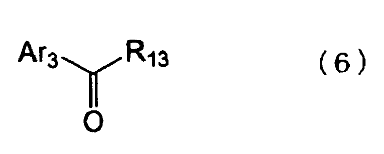

In formula (6), Ar₃ represents an aromatic group or a heteroaromatic group, each of which may have a substituent; and R₁₃ represents a monovalent nonmetallic atomic group. R₁₃ more preferably represents an aromatic group or a hetero- aromatic group, and Ar₃ and R₁₃ may be bonded to each other to form a ring.

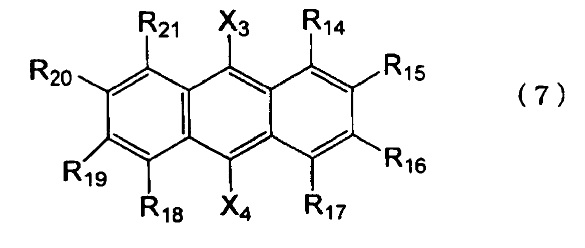

In formula (7), X₃, X₄, R₁₄ to R₂₁ each represents a monovalent nonmetallic atomic group, and X₃ and X₄ each more preferably represents an electron-donating group having a negative Hammett's substitution constant.

The examples of the preferred monovalent nonmetallic atomic groups represented by X₁ to X₄, R₄, R₆ to R₂₁ in formulae (4) to (7) include a hydrogen atom, an alkyl group (e.g., a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a t-butyl group, an isopentyl group, a neopentyl group, a 1-methylbutyl group, an isohexyl group, a 2-ethylhexyl group, a 2-methylhexyl group, a cyclohexyl group, a cyclopentyl group, a 2-norbornyl group, a chloromethyl group, a bromomethyl group, a 2-chloroethyl group, a trifluoromethyl group, a methoxymethyl group, a methoxyethoxyethyl group, an allyloxy- methyl group, a phenoxymethyl group, a methylthiomethyl group, a tolylthiomethyl group, an ethylaminoethyl group, a diethyl- aminopropyl group, a morpholinopropyl group, an acetyloxy- methyl group, a benzoyloxymethyl group, an N-cyclohexyl- carbamoyloxyethyl group, an N-phenylcarbamoyloxyethyl group, an acetylaminoethyl group, an N-methylbenzoylaminopropyl group, a 2-oxyethyl group, a 2-oxypropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropyl- carbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropyl- sulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonoxypropyl group, a phosphonatoxybutyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenyl- methyl group, a 2-propynyl group, a 2-butynyl group, a 3-butynyl group, etc.), an aryl group (e.g., a phenyl group, a biphenyl group, a naphthyl group, a tolyl group, a xylyl group, a mesityl group, a cumenyl group, a chlorophenyl group, a bromophenyl group, a chloromethylphenyl group, a hydroxy- phenyl group, a methoxyphenyl group, an ethoxyphenyl group, a phenoxyphenyl group, an acetoxyphenyl group, a benzoyloxy- phenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxycarbonylphenyl group, a phenoxycarbonylphenyl group, an N-phenylcarbamoylphenyl group, a cyanophenyl group, a sulfophenyl group, a sulfonato- phenyl group, a phosphonophenyl group, a phosphonatophenyl group, etc.), a heteroaryl group (e.g., thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indoyl, indazole, purine, quinolizine, isoquinoline, phthalazine, naphthyridine, quinazoline, cinnoline, pteridine, carbazole, carboline, phenanthrine, acridine, perimidine, phenanthroline, phthalazine, phenarsazine, phenoxazine, furazane, phenoxazine, etc.), an alkenyl group (e. g. , a vinyl group, a 1-propenyl group, a 1-butenyl group, a cinnamyl group, a 2-chloro-1-ethenyl group, etc.), an alkynyl group (e.g., an ethynyl group, a 1-propynyl group, a 1-butynyl group, a trimethylsilylethynyl group, a halogen atom (-F, -Br, -Cl, -I), a hydroxyl group, an alkoxyl group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N- diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyl- oxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl- N-alkylureido group, an N'-alkyl-N-arylureido group, an N',N'-dialkyl-N-alkylureido group, an N',N'-dialkyl-N-aryl- ureido group, an N'-aryl-N-alkylureido group, an N'-aryl- N-arylureido group, an N',N'-diaryl-N-alkylureido group, an N',N'-diaryl-N-arylureido group, an N'-alkyl-N'-aryl-N- alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-aryl- carbamoyl group, an alkylsulfinyl group, an arylsulfinyl group, an alkylsulfonyl group, an arylsulfonyl group, a sulfo group (-SO₃H) and a conjugate base group thereof (hereinafter referred to as a sulfonato group), an alkoxysulfonyl group, an aryloxysulfonyl group, a sulfinamoyl group, an N-alkyl- sulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and a conjugate base group thereof (hereinafter referred to as a phosphonato group), a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and a conjugate base group thereof (hereinafter referred to as an alkylphosphonato group), a monoarylphosphono group (-PO₃H(aryl)) and a conjugate base group thereof (hereinafter referred to as an arylphosphonato group), a phosphonoxy group (-OPO₃H₂) and a conjugate base group thereof (hereinafter referred to as a phosphonatoxy group), a dialkylphosphonoxy group (-OPO₃(alkyl)₂), a diarylphosphonoxy group (-OPO₃(aryl)₂), an alkylarylphosphonoxy group (-OPO₃(alkyl)(aryl)), a monoalkylphosphonoxy group (-OPO₃H(alkyl)) and a conjugate base group thereof (herein- after referred to as an alkylphosphonatoxy group), a monoaryl- phosphonoxy group (-OPO₃H(aryl)) and a conjugate base group thereof (hereinafter referred to as an arylphosphonatoxy group), a cyano group, a nitro group, etc. Of the above substituents, a hydrogen atom, an alkyl group, an aryl group, a halogen atom, an alkoxyl group and an acyl group are especially preferred.

In formula (4), as the basic nucleus of the dye formed by Y conjointly with the adjacent A and the adjacent carbon atom, a 5-, 6- or 7-membered nitrogen-containing or sulfur-containing heterocyclic ring is exemplified, and a 5- or 6-membered heterocyclic ring is preferred.

As the examples of the nitrogen-containing heterocyclic rings, those known as constituting the basic nuclei in the merocyanine dyes described in L.G. Brooker et al., J. Am. Chem. Soc., 73, pp. 5326 to 5358 (1951) and the bibliography cited therein can be preferably used. The specific examples thereof include thiazoles (e.g., thiazole, 4-methylthiazole, 4-phenylthiazole, 5-methylthiazole, 5-phenylthiazole, 4,5-dimethylthiazole, 4,5-diphenylthiazole, 4,5-di(p- methoxyphenylthiazole), 4-(2-thienyl)thiazole, etc.), benzothiazoles (e.g., benzothiazole, 4-chlorobenzothiazole, 5-chlorobenzothiazole, 6-chlorobenzothiazole, 7-chloro- benzothiazole, 4-methylbenzothiazole, 5-methylbenzothiazole, 6-methylbenzothiazole, 5-bromobenzothiazole, 4-phenylbenzothiazole, 5-phenylbenzothiazole, 4-methoxybenzothiazole, 5-methoxybenzothiazole, 6-methoxybenzothiazole, 5-iodobenzothiazole, 6-iodobenzothiazole, 4-ethoxybenzothiazole, 5-ethoxybenzothiazole, tetrahydrobenzothiazole, 5,6-dimethoxybenzothiazole, 5,6-dioxymethylenebenzothiazole, 5-hydroxybenzothiazole, 6-hydroxybenzothiazole, 6-dimethylaminobenzothiazole, 5-ethoxycarbonylbenzothiazole, etc.), naphthothiazoles (e.g., naphtho[1,2]thiazole, naphtho[2,1]-thiazole, 5-methoxynaphtho[2,1]thiazole, 5-ethoxynaphtho-[2,1]thiazole, 8-methoxynaphtho[1,2]thiazole, 7-methoxynaphtho[1,2]thiazole, etc.), thianaphtheno-7',6',4,5- thiazoles (e.g., 4'-methoxythianaphtheno-7',6',4,5-thiazole, etc.), oxazoles (e.g., 4-methyloxazole, 5-methyloxazole, 4-phenyloxazole, 4,5-diphenyloxazole, 4-ethyloxazole, 4,5-dimethyloxazole, 5-phenyloxazole, etc.), benzoxazoles (e.g., benzoxazole, 5-chlorobenzoxazole, 5-methylbenzoxazole, 5-phenylbenzoxazole, 6-methylbenzoxazole, 5,6-dimethylbenzoxazole, 4,6-dimethylbenzoxazole, 6-methoxybenzoxazole, 5-methoxybenzoxazole, 4-ethoxybenzoxazole, 5-chlorobenzoxazole, 6-methoxybenzoxazole, 5-hydroxybenzoxazole, 6-hydroxybenzoxazole, etc.), naphthoxazoles (e.g., naphtho-[1,2]oxazole, naphtho[2,1]oxazole, etc.), selenazoles (e.g., 4-methylselenazole, 4-phenylselenazole, etc.), benzoselenazoles (e.g., benzoselenazole, 5-chlorobenzoselenazole, 5-methoxybenzoselenazole, 5-hydroxybenzoselenazole, tetrahydrobenzoselenazole, etc.), naphthoselenazoles (e.g., naphtho[1,2]selenazole, naphtho[2,1]selenazole, etc.), thiazolines (e.g., thiazoline, 4-methylthiazoline, etc.), 2-quinolines (e.g., quinoline, 3-methylquinoline, 5-methylquinoline, 7-methylquinoline, 8-methylquinoline, 6-chloroquinoline, 8-chloroquinoline, 6-methoxyquinoline, 6-ethoxyquinoline, 6-hydroxyquinoline, 8-hydroxyquinoline, etc.), 4-quinolines (e.g., quinoline, 6-methoxyquinoline, 7-methylquinoline, 8-methylquinoline, etc.), 1-isoquinolines (e.g., isoquinoline, 3,4-dihydroisoquinoline, etc.), 3-iso- quinolines (e.g., isoquinoline, etc.), benzimidazoles (e.g., 1,3-diethylbenzimidazole, 1-ethyl-3-phenylbenzimidazole, etc.), 3,3-dialkylindolenines (e.g., 3,3-dimethylindolenine, 3,3,5-trimethylindolenine, 3,3,7-trimethylindolenine, etc.), 2-pyridines (e.g., pyridine, 5-methylpyridine, etc.), and 4-pyridines (e.g., pyridine, etc.).

As the examples of the sulfur-containing heterocyclic rings, e.g., the dithiol partial structures in the dyes disclosed in JP-A-3-296759 can be exemplified.

As the specific examples, benzodithiols (e.g., benzodithiol, 5-t-butylbenzodithiol, 5-methylbenzodithiol, etc.), naphthodithiols (e.g., naphtho[1,2]dithiol, naphtho-[2,1]dithiol, etc.), and dithiols (e.g., 4,5-dimethyldithiols, 4-phenyldithiols, 4-methoxycarbonyldithiols, 4,5-dimethoxycarbonylbenzodithiols, 4,5-ditrifluoromethyldithiol, 4,5-dicyanodithiol, 4-methoxycarbonylmethyldithiol, 4-carboxymethyldithiol, etc.) can be exemplified.

In the above description of the heterocyclic rings, the names of heterocyclic ring mother skeletons are used for convenience' sake in accordance with the custom, but in the case where a heterocyclic ring forms a basic skeletal partial structure of a sensitizing dye, e.g., in the case of a benzothiazole skeleton, it is introduced in the form of an alkylidene substituent lowered in the degree of unsaturation by one, such as a 3-substituted-2(3H)-benzothiazolylidene group.

Of the sensitizing dyes having absorption maximum in the wavelength region of from 360 to 450 nm, a dye represented by the following formula (8) is more preferred in view of high sensitivity.

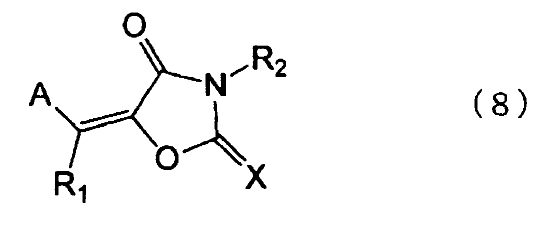

In formula (8), A represents an aromatic ring or a heterocyclic ring that may have a substituent; X represents an oxygen atom, a sulfur atom, or NR₃; R₁, R₂ and R₃ each represents a hydrogen atom or a monovalent nonmetallic atomic group, and A and R₁, and R₂ and R₃ may be bonded to each other to form an aliphatic or aromatic ring.

Formula (8) is described in more detail. R₁, R₂ and R₃ each represents a hydrogen atom or a monovalent nonmetallic atomic group, preferably a substituted or unsubstituted alkyl group, a substituted or unsubstituted alkenyl group, a substituted or unsubstituted aryl group, a substituted or unsubstituted aromatic heterocyclic ring residue, a substituted or unsubstituted alkoxyl group, a substituted or unsubstituted alkylthio group, a hydroxyl group, or a halogen atom.

The preferred examples of R₁, R₂ and R₃ are specifically described below. As the preferred examples of the alkyl groups, straight chain, branched, and cyclic alkyl groups having from 1 to 20 carbon atoms can be exemplified, specifically a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a t-butyl group, an isopentyl group, a neopentyl group, a 1-methylbutyl group, an isohexyl group, a 2-ethylhexyl group, a 2-methylhexyl group, a cyclohexyl group, a cyclopentyl group, and a 2-norbornyl group can be exemplified. Of these groups, straight chain alkyl groups having from 1 to 12 carbon atoms, branched alkyl groups having from 3 to 12 carbon atoms, and cyclic alkyl groups having from 5 to 10 carbon atoms are more preferred.

As the substituents of the substituted alkyl group, monovalent nonmetallic atomic groups exclusive of a hydrogen atom are used. The examples of the monovalent nonmetallic atomic groups include a halogen atom (-F, -Br, -Cl, -I), a hydroxyl group, an alkoxyl group, an aryloxy group, a mercapto group, an alkylthio group, an arylthio group, an alkyldithio group, an aryldithio group, an amino group, an N-alkylamino group, an N, N-dialkylamino group, an N-arylamino group, an N,N- diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyl- oxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl- N-alkylureido group, an N'-alkyl-N-arylureido group, an N',N'-dialkyl-N-alkylureido group, an N',N'-dialkyl-N- arylureido group, an N'-aryl-N-alkylureido group, an N'-aryl- N-arylureido group, an N',N'-diaryl-N-alkylureido group, an N',N'-diaryl-N-arylureido group, an N'-alkyl-N'-aryl-N- alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-aryl- carbamoyl group, an alkylsulfinyl group, an arylsulfinyl group, an alkylsulfonyl group, an arylsulfonyl group, a sulfo group (-SO₃H) and a conjugate base group thereof (hereinafter referred to as a sulfonato group), an alkoxysulfonyl group, an aryloxysulfonyl group, a sulfinamoyl group, an N-alkyl- sulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and a conjugate base group thereof (hereinafter referred to as a phosphonato group), a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and a conjugate base group thereof (hereinafter referred to as an alkylphosphonato group), a monoaryl- phosphono group (-PO₃H(aryl)) and a conjugate base group thereof (hereinafter referred to as an arylphosphonato group), a phosphonoxy group (-OPO₃H₂) and a conjugate base group thereof (hereinafter referred to as a phosphonatoxy group), a dialkylphosphonoxy group (-OPO₃(alkyl)₂), a diarylphosphonoxy group (-OPO₃(aryl)₂), an alkylarylphosphonoxy group (-OPO₃(alkyl)(aryl)), a monoalkylphosphonoxy group (-OPO₃H(alkyl)) and a conjugate base group thereof (herein- after referred to as an alkylphosphonatoxy group), a monoarylphosphonoxy group (-OPO₃H(aryl)) and a conjugate base group thereof (hereinafter referred to as an arylphosphonatoxy group), a cyano group, a nitro group, an aryl group, a hetero- aryl group, an alkenyl group, and an alkynyl group.

As the specific examples of the alkyl groups in these substituents, the above alkyl groups are exemplified, and as the specific examples of the aryl groups, a phenyl group, a biphenyl group, a naphthyl group, a tolyl group, a xylyl group, a mesityl group, a cumenyl group, a chlorophenyl group, a bromophenyl group, a chloromethylphenyl group, a hydroxy- phenyl group, a methoxyphenyl group, an ethoxyphenyl group, a phenoxyphenyl group, an acetoxyphenyl group, a benzoyloxy- phenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxycarbonylphenyl group, a phenoxycarbonylphenyl group, an N-phenylcarbamoylphenyl group, a cyanophenyl group, a sulfophenyl group, a sulfonato- phenyl group, a phosphonophenyl group, and a phosphonatophenyl group are exemplified.

As the preferred heteroaryl groups represented by R₁, R₂ and R₃, monocyclic or polycyclic aromatic rings containing at least one of nitrogen, oxygen and sulfur atoms are used. The examples of especially preferred heteroaryl groups include, e.g., thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indoyl, indazole, purine, quinolizine, isoquinoline, phthalazine, naphthyridine, quinazoline, cinnoline, pteridine, carbazole, carboline, phenanthrine, acridine, perimidine, phenanthroline, phthalazine, phenarsazine, phenoxazine, and furazane. These heteroaryl rings may further be benzo-condensed or may have a substituent.

As the examples of the preferred alkenyl groups represented by R₁, R₂ and R₃, a vinyl group, a 1-propenyl group, a 1-butenyl group, a cinnamyl group, a 2-chloro-1-ethenyl group, etc., are exemplified, and as the examples of the alkynyl groups, an ethynyl group, a 1-propynyl group, a 1-butynyl group, a trimethylsilylethynyl group, etc., are exemplified. As G₁ in the acyl group (G₁CO-), a hydrogen atom and the above alkyl groups and aryl groups can be exemplified. Of these substituents, the more preferred examples include a halogen atom (-F, -Br, -Cl, -I), an alkoxyl group, an aryloxy group, an alkylthio group, an arylthio group, an N-alkylamino group, an N,N-dialkylamino group, an acyloxy group, an N-alkyl- carbamoyloxy group, an N-arylcarbamoyloxy group, an acylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N-alkyl-N-arylcarbamoyl group, a sulfo group, a sulfonato group, a sulfamoyl group, an N-alkylsulfamoyl group, an N,N-dialkylsulfamoyl group, an N-arylsulfamoyl group, an N-alkyl-N-arylsulfamoyl group, a phosphono group, a phosphonato group, a dialkylphosphono group, a diarylphosphono group, a monoalkylphosphono group, an alkyl- phosphonato group, a monoarylphosphono group, an aryl- phosphonato group, a phosphonoxy group, a phosphonatoxy group, an aryl group, and an alkenyl group.

On the other hand, as the alkylene groups in the substituted alkyl groups, divalent organic residues obtained by removing any one hydrogen atom on the above alkyl groups having from 1 to 20 carbon atoms can be exemplified, preferably straight chain alkylene groups having from 1 to 12 carbon atoms, branched alkylene groups having from 3 to 12 carbon atoms, and cyclic alkylene groups having from 5 to 10 carbon atoms are exemplified.

The specific examples of the preferred substituted alkyl groups represented by R₁, R₂ or R₃ obtained by combining any of the above substituents and alkylene group include a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylamino- ethyl group, an N-methylbenzoylaminopropyl group, a 2-oxo- ethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoyl- methyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N- dipropylsulfamoyl- propyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphono- butyl group, a methylphosphonatobutyl group, a tolyl- phosphonohexyl group, a tolylphosphonatohexyl group, a phosphonoxypropyl group, a phosphonatoxybutyl group, a benzyl group, a phenethyl group, an α -methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenyl- methyl group, a 2-propynyl group, a 2-butynyl group, and a 3-butynyl group.

As the examples of preferred aryl groups represented by R₁, R₂ or R₃, rings formed by condensation of from 1 to 3 benzene rings, and rings formed by condensation of benzene rings and 5-membered unsaturated rings are exemplified. Specifically, a phenyl group, a naphthyl group, an anthryl group, a phenanthryl group, an indenyl group, an acenaphthenyl group, and a fluorenyl group can be exemplified, and of these groups, a phenyl group and a naphthyl group are more preferred.

As the examples of preferred substituted aryl groups represented by R¹, R² or R³, aryl groups having monovalent nonmetallic atomic groups (exclusive of a hydrogen atom) as the substituents on the above ring-forming carbon atoms of aryl groups are exemplified. As the examples of preferred substituents, the above alkyl groups, substituted alkyl groups, and the groups described above as the substituents of the substituted alkyl groups can be exemplified.

As the specific examples of preferred substituted aryl groups, a biphenyl group, a tolyl group, a xylyl group, a mesityl group, a cumenyl group, a chlorophenyl group, a bromophenyl group, a fluorophenyl group, a chloromethylphenyl group, a trifluoromethylphenyl group, a hydroxyphenyl group, a methoxyphenyl group, a methoxyethoxyphenyl group, an allyloxyphenyl group, a phenoxyphenyl group, a methylthio- phenyl group, a tolylthiophenyl group, an ethylaminophenyl group, a diethylaminophenyl group, a morpholinophenyl group, an acetyloxyphenyl group, a benzoyloxyphenyl group, an N-cyclohexylcarbamoyloxyphenyl group, an N-phenylcarbamoyloxyphenyl group, an acetylaminophenyl group, an N-methylbenzoylaminophenyl group, a carboxyphenyl group, a methoxycarbonylphenyl group, an allyloxycarbonylphenyl group, a chlorophenoxycarbonylphenyl group, a carbamoylphenyl group, an N-methylcarbamoylphenyl group, an N,N-dipropylcarbamoyl- phenyl group, an N-(methoxyphenyl)carbamoylphenyl group, an N-methyl-N-(sulfophenyl)carbamoylphenyl group, a sulfophenyl group, a sulfonatophenyl group, a sulfamoylphenyl group, an N-ethylsulfamoylphenyl group, an N,N-dipropylsulfamoylphenyl group, an N-tolylsulfamoylphenyl group, an N-methyl-N-(phosphonophenyl) sulfamoylphenyl group, a phosphonophenyl group, a phosphonatophenyl group, a diethylphosphonophenyl group, a diphenylphosphonophenyl group, a methylphosphono- phenyl group, a methylphosphonatophenyl group, a tolyl- phosphonophenyl group, a tolylphosphonatophenyl group, an allyl group, a 1-propenylmethylphenyl group, a 2-butenyl- phenyl group, a 2-methylallylphenyl group, a 2-methyl- propenylphenyl group, a 2-propynylphenyl group, a 2-butynyl- phenyl group, and a 3-butynylphenyl group can be exemplified.

In the next place, A in formula (8) is described. A represents an aromatic ring or a heterocyclic ring that may have a substituent, and as the specific examples of the aromatic rings or heterocyclic rings that may have a substituent, the same examples as described in R₁, R₂ and R₃ in formula (8) can be exemplified.

A sensitizing dye represented by formula (8) is obtained by a condensation reaction of the above acidic nucleus or an acidic nucleus having an active methylene group with a substituted or unsubstituted aromatic ring or heterocyclic ring, and JP-B-59-28329 can be referred to in the synthesis.

The preferred specific examples (D1) to (D42) of the compounds represented by formula (8) are shown below. With respect to isomers by a double bond bonding an acidic nucleus and a basic nucleus, they are not restricted to either isomer.

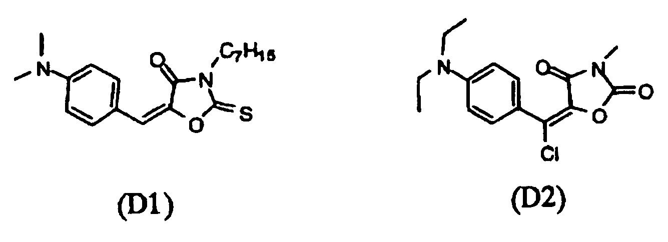

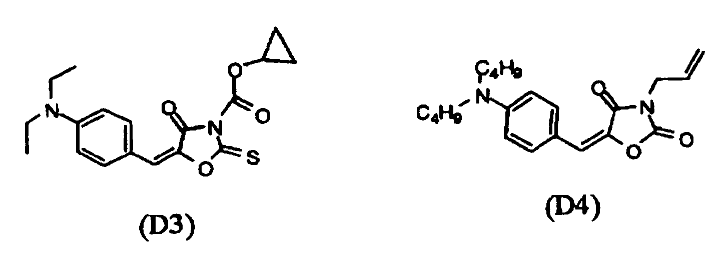

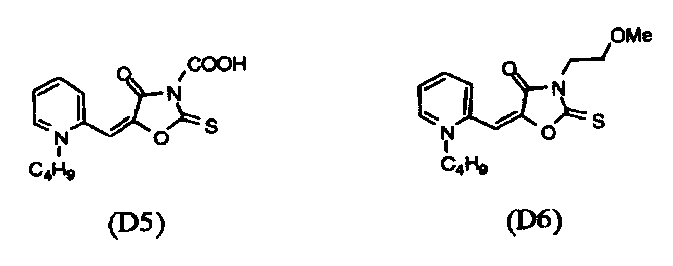

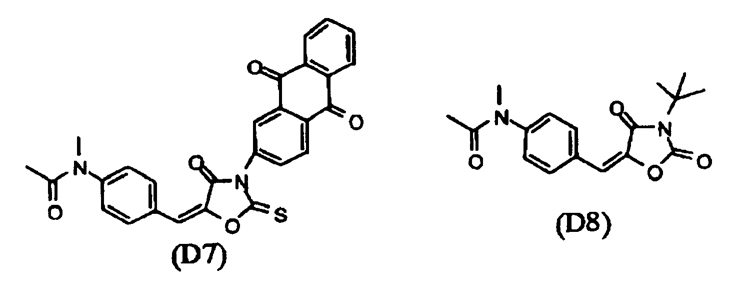

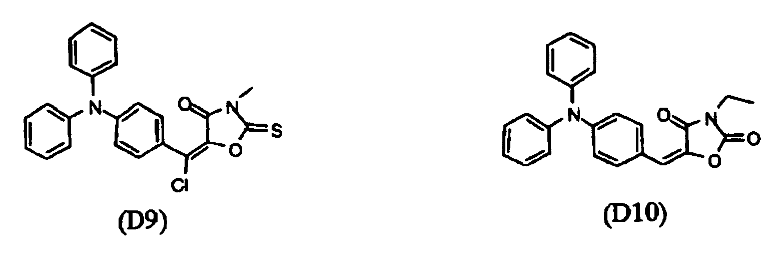

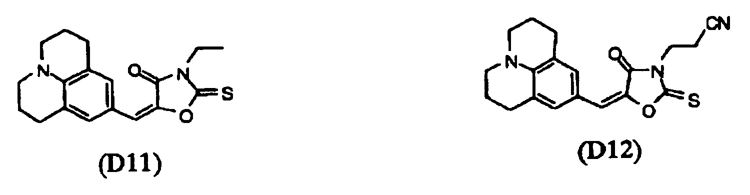

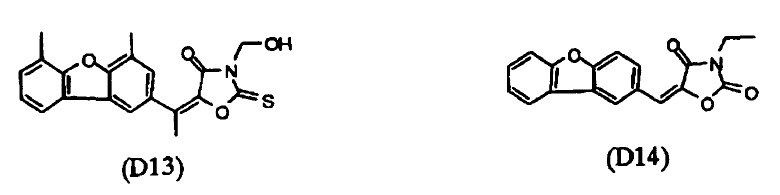

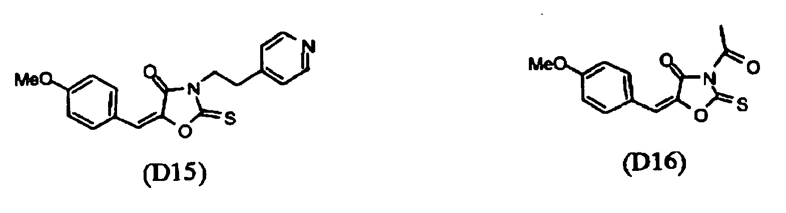

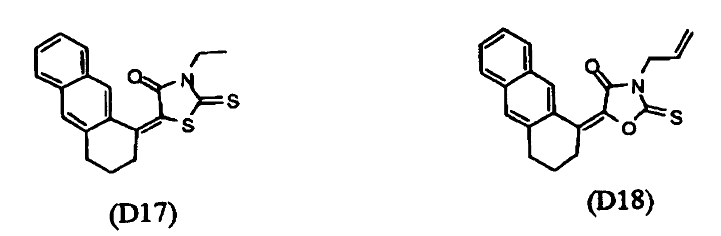

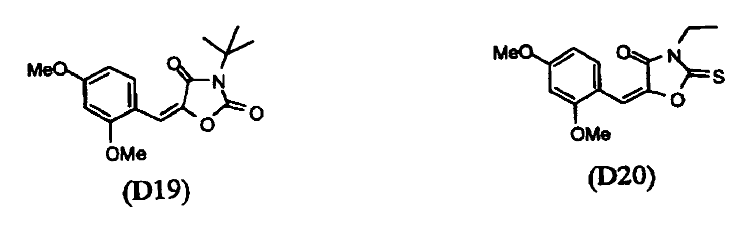

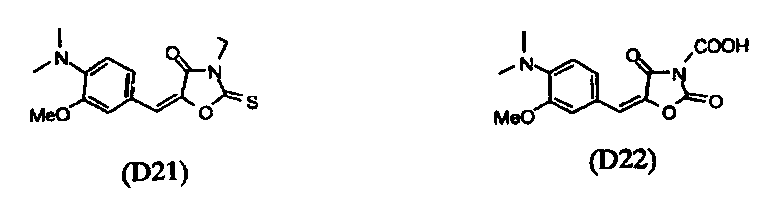

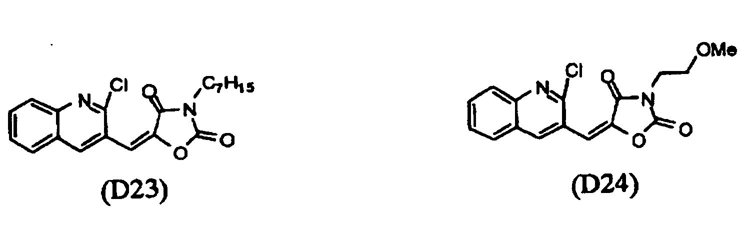

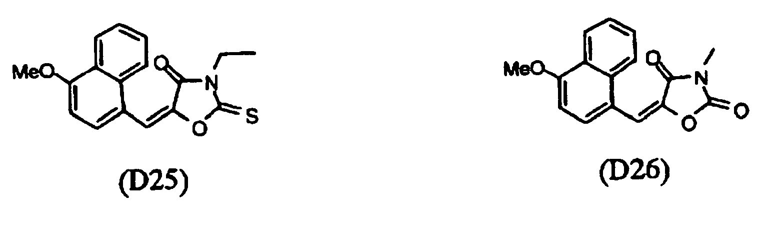

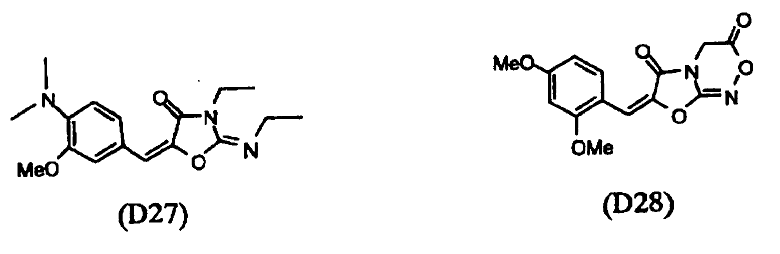

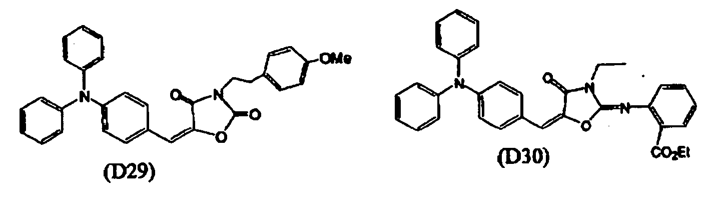

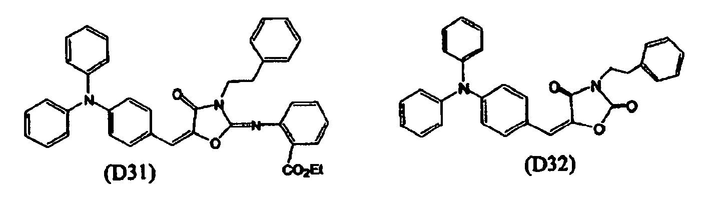

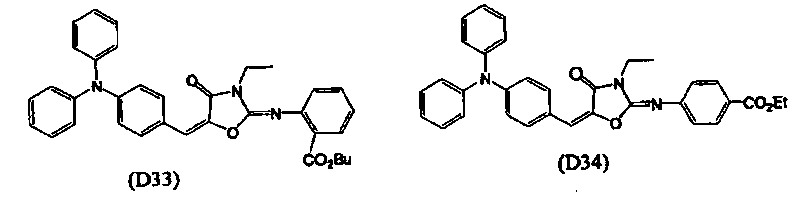

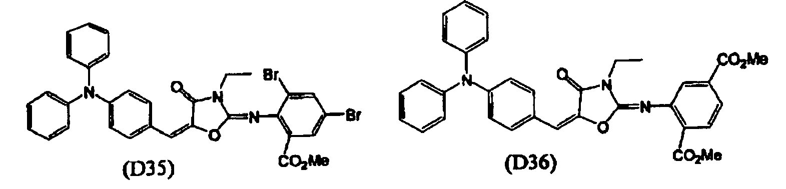

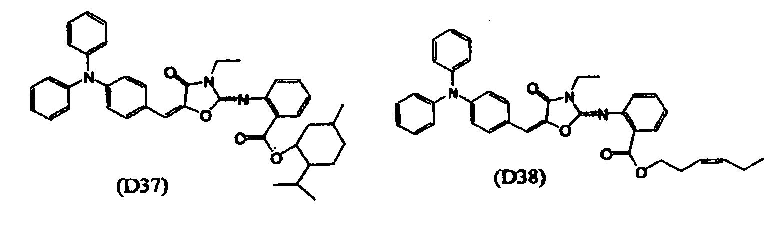

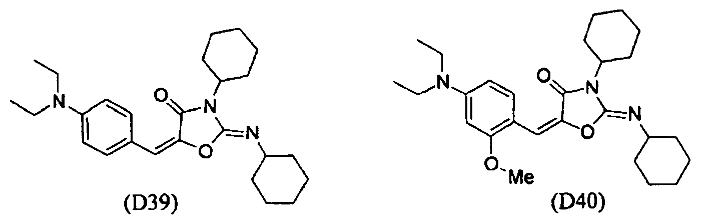

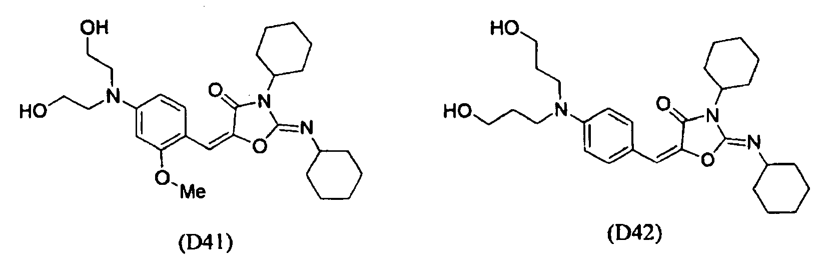

These sensitizing dyes differ in extinction coefficients by their structures, and so the extinction coefficient varies by the structure of the sensitizing dye to be used. The optimal addition amount is the amount such that the extinction coefficient of a sensitizing dye finished as a photosensitive layer to the emission wavelength of laser is 0.6 or less, preferably from 0.05 to 0.55, more preferably from 0.1 to 0.5, and still more preferably from 0.1 to 0.45.

### Photopolymerization initiator:

Photopolymerization initiators for use in the invention contained in a photosensitive layer are described. As photopolymerization initiators contained in a photosensitive layer in the invention, various photopolymerization initiators known in patents and literatures, and the combinations of two or more kinds of photopolymerization initiators can be arbitrarily selected and used. Incidentally, in the invention photopolymerization initiators used alone and the systems of combination of two or more photopolymerization initiators are generally called merely photopolymerization initiators.

For example, when lights in the vicinity of 400 nm are used as light sources, compounds such as benzyl, benzoyl ether, Michler's ketone, anthraquinone, thioxanthone, acridine, phenazine, benzophenone, hexaarylbisimidazole, etc., are broadly used.

When visible rays higher than 400 nm are used as light sources, various kinds of photopolymerization initiators are supposed, for example, a certain kind of photoreduction dyes as disclosed in U.S. Patent 2,850,445, e.g., Rose Bengale, Eosine, erythrosine, etc., systems of the combination of dyes and photopolymerization initiators, e.g., composite initiator systems of dyes and amines (JP-B-44-20189), combination systems of hexaarylbiimidazole, radical generators and dyes (JP-B-45-37377), systems of hexaarylbiimidazole and p-dialkylaminobenzylidene ketone (JP-B-47-2528, JP-A-54- 155292), systems of cyclic cis-α-dicarbonyl compounds and dyes (JP-A-48-84183), systems of cyclic triazine and merocyanine dyes (JP-A-54-151024), systems of 3-ketocoumarin and activators (JP-A-52-112681, JP-A-58-15503), systems of biimidazole, styrene derivatives and thiols (JP-A-59-140203), systems of organic peroxides and dyes (JP-A-59-1504, JP-A-59-140203, JP-A-59-189340, JP-A-62-174203, JP-B-62-1641, U.S. Patent 4, 766, 055), systems of dyes and active halogen compounds (JP-A-63-178105, JP-A-63-258903, JP-A-2-63054), systems of dyes and borate compounds (JP-A-62-143044, JP-A-62-150242, JP-A-64-13140, JP-A-64-13141, JP-A-64-13142, JP-A-64-13143, JP-A-64-13144, JP-A-64-17048, JP-A-1-229003, JP-A-1-298348, JP-A-1-138204), and systems of dyes having a rhodanine ring and radical generators (JP-A-2-179643, JP-A-2-244050) can be exemplified.

As especially preferred photopolymerization initiators, hexaarylbisimidazole compounds can be exemplified. As hexaarylbisimidazole compounds, various compounds as disclosed in EP-A-24629, EP-A-107792, U.S. Patent 4,410,621, EP-A-215453 and German Patent Application No. 3,211,312 can be used.

As the preferred examples, 2,4,5,2',4',5'-hexaphenylbisimidazole, 2,2'-bis(2-chlorophenyl)-4,5,4',5'-tetraphenylbisimidazole, 2,2'-bis(2-bromophenyl)-4,5,4',5'-tetraphenylbisimidazole, 2,2'-bis(2,4-dichlorophenyl)-4,5,4',5'-tetraphenylbisimidazole, 2,2'-bis(2-chlorophenyl)-4,5,4',5'-tetrakis(3-methoxyphenyl)bisimidazole, 2,5,2',5'-tetrakis(2-chlorophenyl)-4,4'-bis(3,4-dimethoxyphenyl)bisimidazole, 2,2'-bis(2,6-dichlorophenyl)-4,5,4',5'-tetraphenylbisimidazole, 2,2'-bis(2-nitrophenyl)-4,5,4',5'-tetraphenylbisimidazole, 2,2'-di-o-tolyl-4,5,4',5'-tetraphenylbisimidazole, 2,2'-bis(2-ethoxyphenyl)-4,5,4',5'-tetraphenylbisimidazole, and 2,2'-bis-(2,6-difluorophenyl)-4,5,4',5'-tetraphenylbisimidazole can be exemplified.

Two or more kinds of hexaarylbisimidazole compounds can be used in combination.

These hexaarylbisimidazole compounds are used in a range of from 0.05 to 50 mass parts per 100 mass parts of the above polymerizable compound, and preferably from 0.2 to 30 mass parts.

The later described other photopolymerizable initiators may be used in combination with the hexaarylbisimidazole compounds.

It is known that by the addition of hydrogen-donating compounds, e.g., thiol compounds such as 2-mercaptobenzothiazole, 2-mercaptobenzimidazole, 2-mercaptobenzoxazole, etc., and amine compounds such as N-phenylglycine, N,N- dialkylamino aromatic alkyl ester, etc., to the above photopolymerization initiators according to necessity, photopolymerization initiating performance is further heightened. As the hydrogen-donating compounds having especially high photopolymerization initiating performance and preferably used in the invention, compounds containing a mercapto group are exemplified.

The more preferred examples are mercapto group- containing heterocyclic compounds represented by the following formulae. In formulae (2) and (3), the structures of tautomers are shown.

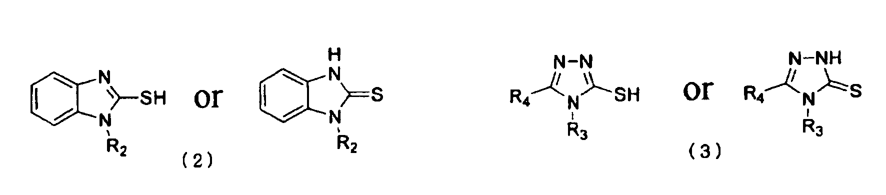

In formulae (2) and (3), R₂, R₃ and R₄ each represents a hydrogen atom, a straight chain or branched alkyl group having from 1 to 18 carbon atoms, which may have a substituent, an alicyclic alkyl group having from 5 to 20 carbon atoms, or an aromatic group, and R₃ and R₄ each can select these groups. As the substituents, a halogen atom, a hydroxyl group, an amino group, a thiol group, an acetyl group, a carboxyl group, etc., are exemplified.

The preferred specific examples (SH1) to (SH20) of the compounds represented by formulae (2) and (3) are shown below. The following structures are shown as -SH group-containing structures of the tautomers. The invention is by no means restricted to the following specific examples.

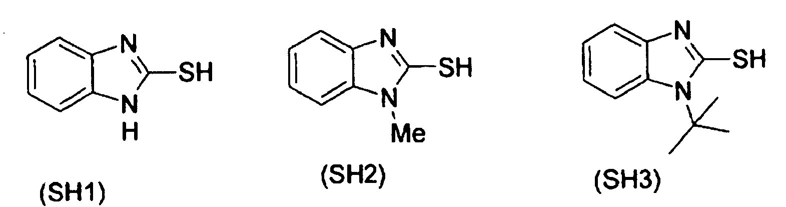

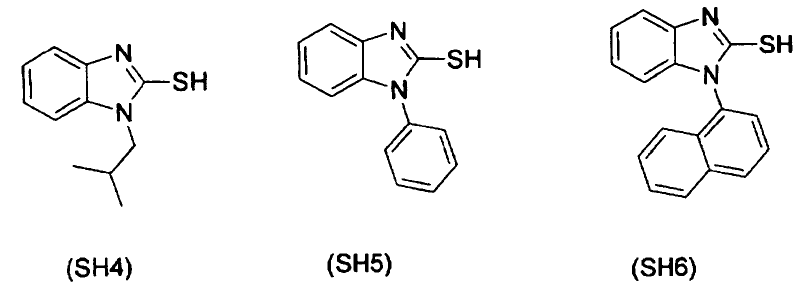

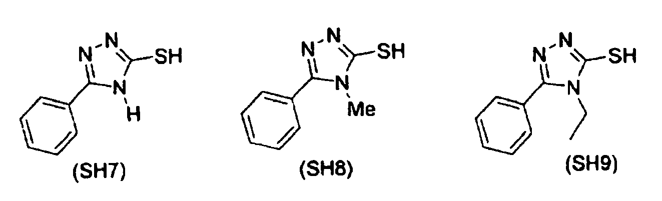

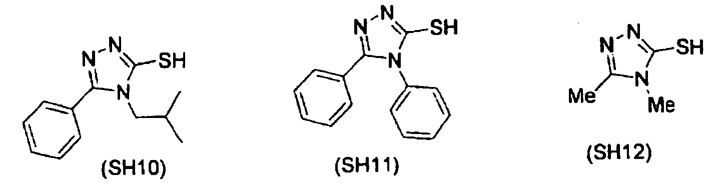

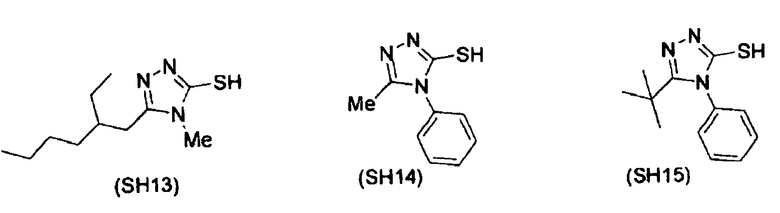

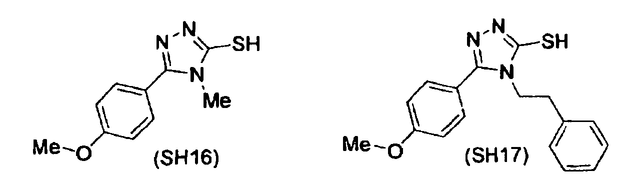

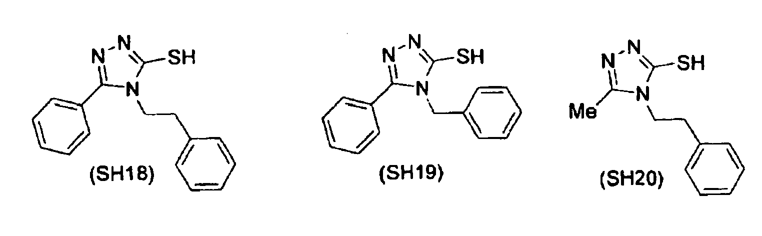

These mercapto group-containing heterocyclic compounds are preferably used in a ratio of from 0.2 to 10.0 mols per mol of the hexaarylbisimidazole compound to be added to, more preferably from 0.5 to 6.0 mols, and most preferably in a ratio of from 0.5 to 4.0 mols. Addition polymerizable compound having an ethylenic unsaturated double bond:

An addition polymerizable compound having an ethylenic unsaturated double bond to be contained in a photosensitive layer of the invention can be arbitrarily selected from among the compounds having at least one, preferably two or more, ethylenic unsaturated double bond.

Such an addition polymerizable compound takes the chemical form of, e.g., a monomer, a prepolymer, i.e., a dimer, a trimer, an oligomer, or a mixture and a polymer of these compounds.

As the examples of monomers, esters of unsaturated carboxylic acids (e.g., acrylic acid, methacrylic acid, itaconic acid, crotonic acid, isocrotonic acid, maleic acid, etc.) and aliphatic polyhydric alcohol compounds, and amides of unsaturated carboxylic acids and aliphatic polyhydric amine compounds are used.

The specific examples of the monomers of the esters of aliphatic polyhydric alcohol compounds and unsaturated carboxylic acids include, as acrylates, ethylene glycol diacrylate, triethylene glycol diacrylate, 1,3-butanediol diacrylate, tetramethylene glycol diacrylate, propylene glycol diacrylate, neopentyl glycol diacrylate, trimethylol- propane triacrylate, trimethylolpropane tri(acryloyloxy- propyl) ether, trimethylolethane triacrylate, hexanediol diacrylate, 1,4-cyclohexanediol diacrylate, tetraethylene glycol diacrylate, pentaerythritol diacrylate, penta- erythritol triacrylate, pentaerythritol tetraacrylate, dipentaerythritol diacrylate, dipentaerythritol penta- acrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, polyester acrylate oligomer, etc.

As methacrylates, the examples include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1, 3-butanediol dimethacrylate, hexanediol dimethacrylate, pentaerythritol dimethacrylate, pentaerythritol trimethacrylate, pentaerythritol tetra- methacrylate, dipentaerythritol dimethacrylate, dipenta- erythritol hexamethacrylate, dipentaerythritol penta- methacrylate, sorbitol trimethacrylate, sorbitol tetra- methacrylate, bis[p-(3-methacryloxy-2-hydroxypropoxy)-phenyl]dimethylmethane, bis[p-(methacryloxyethoxy)phenyl]-dimethylmethane, etc.

As itaconates, the examples include ethylene glycol diitaconate, propylene glycol diitaconate, 1,3-butanediol diitaconate, 1,4-butanediol diitaconate, tetramethylene glycol diitaconate, pentaerythritol diitaconate, sorbitol tetraitaconate, etc.

As crotonates, the examples include ethylene glycol dicrotonate, tetramethylene glycol dicrotonate, pentaerythritol dicrotonate, sorbitol tetradicrotonate, etc.

As isocrotonates, the examples include ethylene glycol diisocrotonate, pentaerythritol diisocrotonate, sorbitol tetraisocrotonate, etc.

As maleates, the examples include ethylene glycol dimaleate, triethylene glycol dimaleate, pentaerythritol dimaleate, sorbitol tetramaleate, etc.

The mixtures of the above ester monomers can also be exemplified.

Further, as the specific examples of the amide monomers of aliphatic polyhydric amine compounds and unsaturated carboxylic acids, methylenebis-acrylamide, methylenebis- methacrylamide, 1,6-hexamethylenebis-acrylamide, 1,6-hexamethylenebis-methacrylamide, diethylenetriamine-tris-acrylamide, xylylenebis-acrylamide, xylylenebismethacrylamide, etc. are exemplified.

In addition, urethane acrylates as disclosed in JP-A-51-37193, polyfunctional acrylates and methacrylates, such as polyester acrylates, and epoxy acrylates obtained by the reaction of epoxy resins with (meth)acrylic acids as disclosed in JP-A-48-64183, JP-B-49-43191 and JP-B-52-30490 can be exemplified. Further, the photo-curable monomers and oligomers introduced into Bulletin of Nippon Setchaku Kyokai, Vol. 20, No. 7, pp. 300-308 (1984) can also be used.

As specific examples, NK Oligo U-4HA, U-4H, U-6HA, U-6ELH, U-108A, U-1084A, U-200AX, U-122A, U-340A, U-324A, and UA-100 (manufactured by Shin-Nakamura Chemical Co., Ltd.), UA-306H, AI-600, UA-101T, UA-101I, UA-306T, and UA-306I (manufactured by Kyoeisha Chemical Co., Ltd.), Art Resin UN-9200A, UN-3320HA, UN-3320HB, UN-3320HC, SH-380G, SH-500, and SH-9832 (manufactured by Negami Chemical Industrial Co., Ltd.), PLEX6661-O (manufactured by Degussa, Germany) can be exemplified.

Addition polymerizable compounds having an ethylenic unsaturated double bond are preferably used in the range of from 5 to 90 mass% of all the components of a photosensitive layer, and more preferably from 20 to 75 mass%.

### Binder polymer:

The binder polymers for use in a photosensitive layer in the invention are polymers having at least one repeating unit represented by the following formula (1):

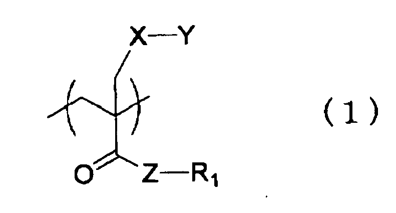

In formula (1), X represents an oxygen atom, a sulfur atom, or an -NH- group; Y represents a hydrogen atom, or a hydrocarbon group having from 1 to 20 carbon atoms which may have a substituent; Z represents an oxygen atom, a sulfur atom, or an -NH- group; and R₁ represents a hydrocarbon group having from 1 to 20 carbon atoms which may have a substituent.

As the hydrocarbon group having from 1 to 20 carbon atoms, an alkyl group having from 1 to 12 carbon atoms, an alicyclic alkyl group having from 5 to 12 carbon atoms, and a group having an aromatic ring and from 6 to 20 carbon atoms are preferably exemplified. As the examples of the substituents, an alkyl group, an alkenyl group, an alkynyl group, an aryl group, an alkoxyl group, an aryloxy group, a halogen atom, an amino group, an alkylamino group, an arylamino group, a carboxyl group, an alkoxycarbonyl group, a sulfo group, a nitro group, a cyano group, an amido group, an alkylsulfonyl group, and an arylsulfonyl group are exemplified.

As the specific examples of the repeating units represented by formula (1), the following (1-1) to (1-9) are shown.

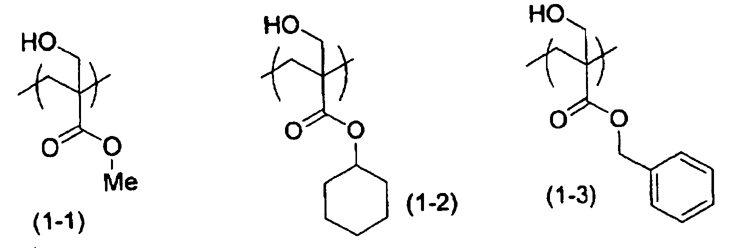

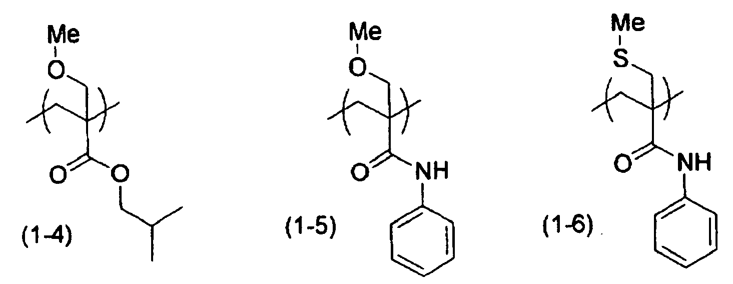

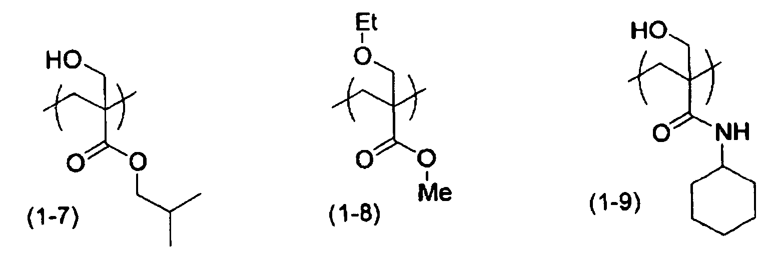

The binder polymers preferably used in the invention not only function as film-forming agents of a photosensitive layer but also should be soluble in an alkali developing solution. That is, organic polymers soluble or swelling in alkaline water are used as the binder polymers. Further, it is more preferred that the binder polymers contain a repeating unit having radical addition/crosslinking property for forming a strong film by photopolymerization. Accordingly, it is preferred for the binder polymers to contain (a) a repeating unit for imparting alkali solubility, and (b) a repeating unit for imparting a radical crosslinking property, besides repeating unit (1), i.e., at least three kinds of repeating units in total. That is, the binder polymers in the invention are preferably polymers obtained by copolymerization of these three components in arbitrary proportion.
(a) The repeating unit for imparting alkali solubility has an alkali-soluble group. As the alkali-soluble groups, a carboxyl group, a sulfon group, a sulfonamido group, an active imino group (-CO-NH-SO₂-), etc., are exemplified, and a carboxyl group and a sulfon group are especially preferred.
(b) The repeating unit for imparting a radical crosslinking property has a radical crosslinkable group. The radical crosslinkable group is a group that makes a polymer binder crosslink in the process of radical polymerization reaction occurring in a photosensitive layer in exposing a photosensitive lithographic printing plate. Radical crosslinking groups are not especially restricted so long as they are groups having such a function, e.g., an ethylenic unsaturated bonding group, an amino group, an epoxy group, etc., are exemplified as addition polymerization reactive functional groups. Functional groups capable of becoming radicals with irradiation can also be used, and as such groups, e.g., a thiol group, a halogen group, an onium salt structure, etc., are exemplified. Ethylenic unsaturated bonding group is preferred above all, and a functional group represented by any of the following formulae (9) to (11) is especially preferred.

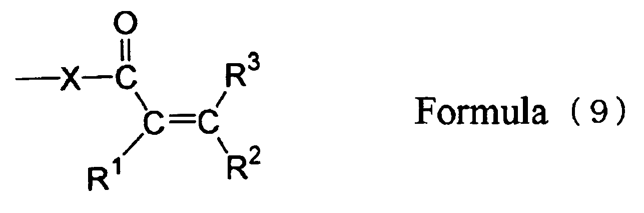

In formula (9), R¹, R² and R³ each represents a monovalent organic group, and R¹ preferably represents a hydrogen atom or an alkyl group that may have a substituent, above all a hydrogen atom and a methyl group are preferred for their high radical reactivity. R² and R³ each represents a hydrogen atom, a halogen atom, an amino group, a carboxyl group, an alkoxycarbonyl group, a sulfo group, a nitro group, a cyano group, an alkyl group that may have a substituent, an aryl group that may have a substituent, an alkoxyl group that may have a substituent, an aryloxy group that may have a substituent, an alkylamino group that may have a substituent, an arylamino group that may have a substituent, an alkylsulfonyl group that may have a substituent, an arylsulfonyl group that may have a substituent, etc., and a hydrogen atom, a carboxyl group, an alkoxycarbonyl group, an alkyl group that may have a substituent, and an aryl group that may have a substituent are preferred for their high radical reactivity.

X represents an oxygen atom, a sulfur atom, or N(R¹²)-, and R¹² represents a hydrogen atom or a monovalent organic group. As R¹², an alkyl group that may have a substituent is exemplified, and above all a hydrogen atom, a methyl group, an ethyl group, and an isopropyl group are preferred for their high radical reactivity.

As the introducible substituents, an alkyl group, an alkenyl group, an alkynyl group, an aryl group, an alkoxyl group, an aryloxy group, a halogen atom, an amino group, an alkylamino group, an arylamino group, a carboxyl group, an alkoxycarbonyl group, a sulfo group, a nitro group, a cyano group, an amido group, an alkylsulfonyl group, an arylsulfonyl group, etc., are exemplified.

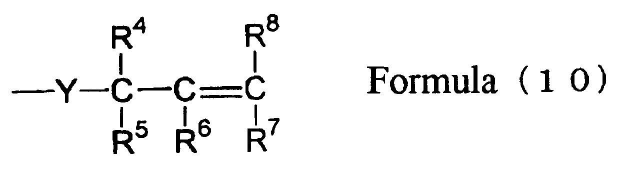

In formula (10), R⁴ to R⁸ each represents a monovalent organic group. R⁴ to R⁸ each preferably represents a hydrogen atom, a halogen atom, an amino group, a dialkylamino group, a carboxyl group, an alkoxycarbonyl group, a sulfo group, a nitro group, a cyano group, an alkyl group that may have a substituent, an aryl group that may have a substituent, an alkoxyl group that may have a substituent, an aryloxy group that may have a substituent, an alkylamino group that may have a substituent, an arylamino group that may have a substituent, an alkylsulfonyl group that may have a substituent, an arylsulfonyl group that may have a substituent, etc., and a hydrogen atom, a carboxyl group, an alkoxycarbonyl group, an alkyl group that may have a substituent, and an aryl group that may have a substituent are preferred.

As the introducible substituents, the same groups as in formula (9) are exemplified. Y represents an oxygen atom, a sulfur atom, or N(R¹²)-. R¹² is the same as R¹² in formula (9), and the preferred examples are also the same.

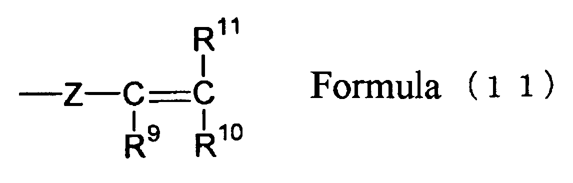

In formula (11), R⁹ preferably represents a hydrogen atom or an alkyl group that may have a substituent, above all a hydrogen atom and a methyl group are preferred for their high radical reactivity. R¹⁰ and R¹¹ each represents a hydrogen atom, a halogen atom, an amino group, a dialkylamino group, a carboxyl group, an alkoxycarbonyl group, a sulfo group, a nitro group, a cyano group, an alkyl group that may have a substituent, an aryl group that may have a substituent, an alkoxyl group that may have a substituent, an aryloxy group that may have a substituent, an alkylamino group that may have a substituent, an arylamino group that may have a substituent, an alkyl- sulfonyl group that may have a substituent, an arylsulfonyl group that may have a substituent, etc., and a hydrogen atom, a carboxyl group, an alkoxycarbonyl group, an alkyl group that may have a substituent, and an aryl group that may have a substituent are preferred for their high radical reactivity.

As the introducible substituents, the same groups as in formula (9) are exemplified. Z represents an oxygen atom, a sulfur atom, N(R¹³)-, or a phenylene group that may have a substituent. R¹³ represents an alkyl group that may have a substituent, and a methyl group, an ethyl group, and an isopropyl group are preferred for their high radical reactivity.

As the specific examples of the repeating units having an alkali-soluble group (a), the compounds having the structure represented by the following formulae (a-1) to (a-13) are exemplified.

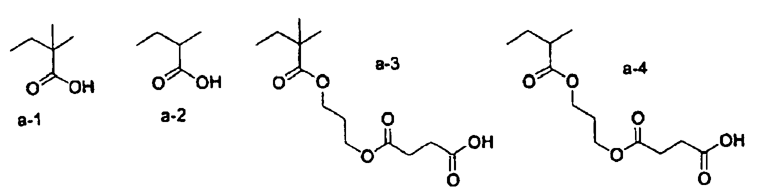

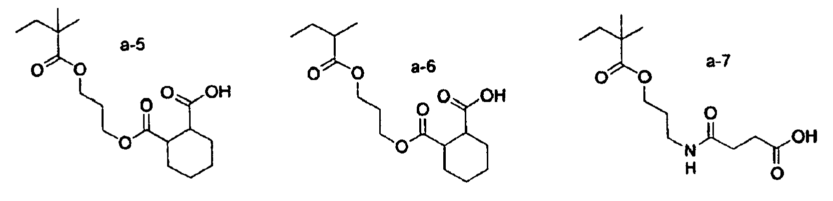

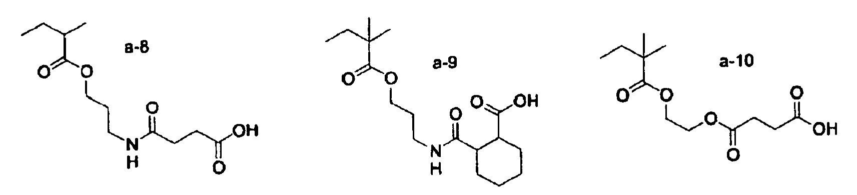

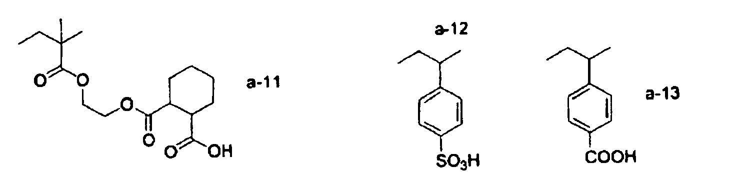

As the specific examples of the repeating units having a radical crosslinking group (b), the compounds having the structure represented by the following formulae (b-1) to (b-11) are exemplified.

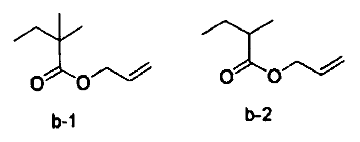

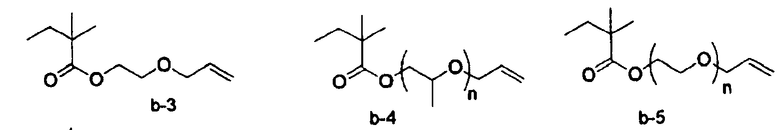

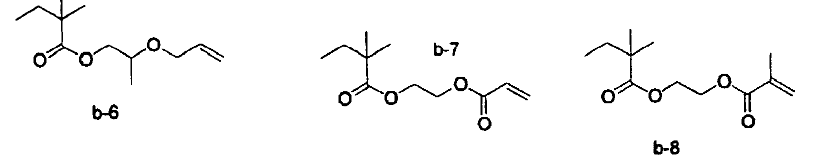

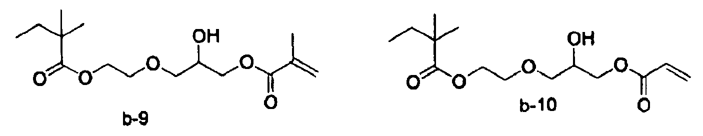

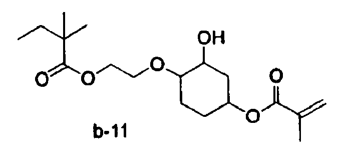

The content of repeating unit (1) is from 1 to 40 units taking the entire repeating units as 100, preferably from 3 to 25 units, and more preferably from 5 to 15 units.

The content of repeating unit (a) is from 5 to 50 units taking the entire repeating units as 100, preferably from 5 to 25 units, and more preferably from 5 to 15 units.

The content of repeating unit (b) is from 5 to 90 units taking the entire repeating units as 100, preferably from 20 to 85 units, and more preferably from 40 to 80 units.

For maintaining the developing property of a photopolymerizable photosensitive layer, it is preferred for the binder polymer used to have proper molecular weight, e.g., a polymer having mass average molecular weight of from 5,000 to 300,000 is especially preferred, and the range of from 20,000 to 150,000 is more preferred.

The binder polymer in the invention can be obtained by the copolymerization of the precursor monomers of the repeating units (1), (a) and (b) according to well-known methods. The precursor monomer of repeating unit (1) is available by the synthesis according to the method described in Basavaiah, D., RaO, A.J., Satyanarayana, T., Chem. Rev. 2003, 103,811.

As preferred combinations of repeating units (1), (a) and (b), the following (PP-1) to (PP-10) are exemplified as specific examples, but the invention is not restricted thereto.

**TABLE 1**

| Specific Example No. | Repeating Unit (1) | Repeating Unit (a) | Repeating Unit (b) |
|---|---|---|---|
| PP-1 | I-3 | a-1 | b-1 |
| PP-2 | I-3 | a-1 | b-8 |
| PP-3 | I-2 | a-1 | b-1 |
| PP-4 | I-2 | a-1 | b-8 |
| PP-5 | I-2 | a-1 | b-11 |
| PP-3 | I-9 | a-3 | b-1 |
| PP-6 | I-9 | a-5 | b-1 |
| PP-7 | I-5 | a-3 | b-1 |
| PP-8 | I-5 | a-3 | b-8 |
| PP-9 | I-1 | a-3 | b-1 |
| PP-10 | I-1 | a-5 | b-8 |

These polymer binders can be contained in an arbitrary amount in a photosensitive layer, but the amount is preferably from 10 to 90 mass%, and more preferably from 30 to 80 mass%, since there are cases where preferred results cannot be obtained in the points of image strength formed and the like when the content exceeds 90 mass%.

### Other photosensitive layer components:

In a photosensitive layer for use in the invention, besides the above fundamental components, it is preferred to use a small amount of thermal polymerization inhibitor for preventing unnecessary thermal polymerization of an addition polymerizable compound having an ethylenic unsaturated double bond during the manufacture or preservation of the composition for forming the photosensitive layer (the photopolymerizable photosensitive composition). As the appropriate thermal polymerization inhibitors, hydroquinone, p-methoxyphenol, di-t-butyl-p-cresol, pyrogallol, t-butylcatechol, benzo- quinone, 4,4'-thiobis(3-methyl-6-t-butylphenol), 2,2'-methylenebis(4-methyl-6-t-butylphenol), N-nitrosophenylhydroxylamine primary cerium salt, and N-nitrosophenylhydroxylamine aluminum salt can be exemplified. The addition amount of thermal polymerization inhibitors is preferably from about 0.01 to about 5 mass% of all the components of the above composition. In addition, if necessary, higher fatty acid derivatives, such as behenic acid and behenic acid amide, may be added and localized on the surface of the photopolymerizable photosensitive layer during the drying process after coating in order to inhibit polymerization hindrance due to oxygen. The addition amount of the higher fatty acid derivatives is preferably from about 0.5 to about 10 mass% of all the components of the photopolymerizable photosensitive composition.

For the purpose of coloring a photosensitive layer, colorants may be added. As the colorants, pigments such as phthalocyanine pigments (C.I. Pigment Blues 15:3, 15:4, 15:6, etc.), azo pigments, carbon black, titanium oxide, etc., and Ethyl Violet, Crystal Violet, azo dyes, anthraquinone dyes, and cyanine dyes are exemplified. The addition amount of dyes and pigments is preferably from about 0.5 to about 5 mass% of all the components of the photopolymerizable photosensitive composition.

For improving the physical properties of a cured film, additives such as inorganic fillers and plasticizers, e.g., dioctyl phthalate, dimethyl phthalate, tricresyl phosphate, etc., may be added. The addition amount of additives is preferably 10 mass% or less of all the components of the photopolymerizable photosensitive composition.

Further, the composition for forming the photosensitive layer can contain a surfactant for improving the coated layer surface properties. As preferred surfactants, e.g., nonionic fluorine surfactants can be exemplified. Formation of photosensitive layer:

The photopolymerizable photosensitive composition in the invention is coated on a support subjected to various surface treatments according to necessity described in detail later, and the photopolymerizable photosensitive composition is dissolved in various organic solvents in coating on a support. The examples of the solvents used here include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ-butyrolactone, methyl lactate, ethyl lactate, etc. These solvents may be used alone or as mixture. The appropriate concentration of the solids content in the coating solution is from 1 to 50 mass%.

The coating amount of the photosensitive layer in the photopolymerizable photosensitive lithographic printing plate in the invention is preferably from about 0.1 to about 10 g/m² in a dry coating amount, more preferably from 0.3 to 5 g/m², and still more preferably from 0.5 to 3 g/m². Protective layer:

In the photopolymerizable photosensitive lithographic printing plate in the invention, an oxygen-shielding protective layer (an overcoat layer) is provided on the photosensitive layer in order to prevent the polymerization hindrance function of oxygen.

The coating amount of the protective layer is preferably from 0.7 to 3.0 g/m². The coating amount of less than 0.7 g/m² sometimes results in the reduction of sensitivity, and when the amount exceeds 3. 0 g/m², there are cases where the load of treatment process increases.

The protective layer contains a water-soluble polyvinyl alcohol having a hydrolyzing rate of 95 mol% or more, and
a water-soluble polymer containing sulfonic acid, or alkali metal salt or ammonium salt of sulfonic acid besides the above water-soluble vinyl polymers (hereinafter, a sulfonic acid group, and alkali metal salt group or ammonium salt group of sulfonic acid are collectively called a sulfonic acid group).

The sulfonic acid group-containing water-soluble polymers are not especially restricted so long as they are easily water-soluble polymers having a sulfonic acid group, but the polymers or copolymers of polymerizable monomers having a sulfonic acid group are preferred.

The examples of the polymerizable monomers having a sulfonic acid group include sulfonic acids such as p-vinyl- benzenesulfonic acid, 2-acrylamide-2-methylpropanesulfonic acid, ethylenesulfonic acid, 2-chloroethylenesulfonic acid, ethylenedisulfonic acid, 1-propene-1-sulfonic acid, 1-propene-2-sulfonic acid, 2-methyl-1,3-propenedisulfonic acid, 1-butyne-1-sulfonic acid, 1-pentene-1-sulfonic acid, 1-hexene-1-sulfonic acid, 2-phenylethylenesulfonic acid, 1-methyl-2-phenylethylene- sulfonic acid, 3-chloroallylsulfonic acid, allylsulfonic acid, 3-chloro-2-butenesulfonic acid, 3-chloromethallylsulfonic acid, methallylsulfonic acid, 3-methyl-2-butene-2-sulfonic acid, 3-phenylallylsulfonic acid, 3-phenylmethallylsulfonic acid, 3-benzylallylsulfonic acid, 2-chloro-4-styrenesulfonic acid, vinyltoluenesulfonic acid, α -methylstyrenesulfonic acid, and alkali metal salts and ammonium salts of these sulfonic acids. Of these monomers, especially preferred monomers having a sulfonic acid group are p-vinylbenzenesulfonic acid, 2-acrylamide-2-methylpropanesulfonic acid and ethylenesulfonic acid. Arbitrary one or two or more of these polymerizable monomers are polymerized, or copolymerized with other monomers.

When these polymerizable monomers are copolymerized with other monomers, any monomers copolymerizable with these monomers having a sulfonic acid group can be used, and as especially preferred examples of other monomers, alkyl acrylates (e.g., methyl acrylate, ethyl acrylate, n-propyl acrylate, isopropyl acrylate, n-butyl acrylate, isobutyl acrylate, n-amyl acrylate, isoamyl acrylate, n-hexyl acrylate, 2-ethylhexyl acrylate, n-octyl acrylate, n-decyl acrylate, 2-hydroxyethyl acrylate, etc.), alkyl methacrylates (e.g., methyl methacrylate, ethyl methacrylate, n-propyl methacrylate, isopropyl methacrylate, n-butyl methacrylate, isobutyl methacrylate, n-amyl methacrylate, 2-ethylhexyl methacrylate, n-octyl methacrylate, n-decyl methacrylate, 2-hydroxyethyl methacrylate, etc.), styrenes (e.g., styrene, o-methylstyrene, m-methylstyrene, p-methylstyrene, 2,4-dimethylstyrene, 2,3-dimethylstyrene, 3,4-dimethylstyrene, 3,5-dimethylstyrene, 2,4,5-trimethylstyrene, 2,4,6-trimethylstyrene, o-ethylstyrene, o-sec-butylstyrene, o-tert-butylstyrene, p-fluorostyrene, 2,5-difluorostyrene, o-chlorostyrene, m-chlorostyrene, p-chlorostyrene, 2,4-dichlorostyrene, 2,5-dichlorostyrene, 2,6-dichlorostyrene, 3,4-dichlorostyrene, p-bromostyrene, p-cyanostyrene, etc.), acrylonitrile, methacrylonitrile, acrylamide, N-sec-butylacrylamide, N-tert-butylacrylamide, N,N-dibutylacrylamide, N-tert-butylmethacrylamide, acrylic acid, methacrylic acid, vinyl acetate, etc., are exemplified.

Of these water-soluble polymers for use in the invention, the especially preferred examples include copolymers of isobutyl methacrylate and 2-acrylamide-2-methylpropane- sulfonic acid, copolymers of methyl methacrylate, ethyl acrylate and 2-acrylamide-2-methylpropanesulfonic acid, copolymers of methyl methacrylate, ethyl acrylate and p-vinylbenzenesulfonic acid, copolymers of methyl methacrylate and p-vinylbenzenesulfonic acid, alkali metal salt groups or ammonium salt groups of these copolymers, and copolymers of (meth)acrylic esters, 2-acrylamide-2-methyl- propanesulfonic acid and p-vinylbenzenesulfonic acid.

The molecular weight of the water-soluble polymers for use in the invention is not restricted so long as the polymers are water-soluble, but as a rule of thumb, the molecular weight is preferably from about 1,000 to about 1,000,000, more preferably from 2, 000 to 100,000, and most preferably from 10, 000 to 100,000.

Further, the amount of the monomer units containing a sulfonic acid group contained in the polymers can also be used in a bread range, and the amount is preferably from 1 to 100 mol% or so, and more preferably from 5 to 100 mol%.

These sulfonic acid group-containing water-soluble polymers are preferably contained in an amount of from 5 to 40 mass% of the total mass of the protective layer, more preferably from 10 to 35 mass%, and still more preferably from 15 to 30 mass%.

As the solvent for coating a protective layer in the photosensitive lithographic printing plate in the invention, water is preferred, but alcohols, e.g., methanol and ethanol, ketones, e.g., acetone and methyl ethyl ketone may be used as mixture with water. The concentration of solids content in the coating solution is preferably from 1 to 20 mass%. Known additives such as surfactants for heightening a coating property and water-soluble plasticizers for improving the physical properties of a film may further be added to the protective layer in the invention. As the water-soluble plasticizers, e.g., propionamido, cyclohexanediol, glycerol, sorbitol, etc., are exemplified. Water-soluble (meth)acrylic polymers may also be added. The coating amount of these additives is preferably from about 0.1 to about 15 g/m² in dry weight, and more preferably from 1.0 to 5.0 g/m² or so.

### Plate-making method:

In the next place, the plate-making method of the photosensitive lithographic printing plate in the invention is described in detail. As the light sources in exposure of the photosensitive lithographic printing plate, it is very preferred to use AlGaInN semiconductor lasers (commercially available InGaN semiconductor lasers, 5 to 30 mW) in the aspect of wavelength characteristics and economically.

Any exposure mechanism (plate setter) may be used such as an internal drum system, an external drum system, and a flat bed system.

Further, the photosensitive layer of the photosensitive lithographic printing plate of the invention can be soluble in neutral water and weak alkaline water by the use of highly water-soluble components, The photosensitive lithographic printing plate comprising such a constitution is capable of on-press development, so that the photosensitive lithographic printing plate of the invention can be used in a system of mounting a printing plate on a printing press and performing exposure and development on the press.

After image exposure, if necessary, the entire surface of the photosensitive layer may be subjected to heat treatment during the time from exposure to development. By this heating, the image-forming reaction in the photosensitive layer is accelerated, which leads to advantages such as the improvement of sensitivity and press life, and stabilization of sensitivity. Further, it is also effective for the image after development to be subjected to entire post-heating or entire exposure for the purpose of the improvement of image strength and press life. Heating before development is generally preferably performed on a moderate condition of 150°C or less. When the temperature is too high, a problem that even a non-image area is fogged occurs. A very severe condition is used in heating after development. The heating range is generally from 200 to 500°C. When the temperature is too low, sufficient image reinforcement cannot be achieved, while when it is too high, problems of the degradation of the support and the thermal decomposition of the image area are generated.

### Developing solution:

Developing solutions for use in the plate making of the lithographic printing plate are not especially restricted, but developing solutions containing an inorganic alkali salt and a nonionic surfactant and having pH of 11.0 to 12.5 are preferably used.

Inorganic alkali salts can be arbitrarily used, for example, inorganic alkali agents, e.g., sodium hydroxide, potassium hydroxide, ammonium hydroxide, lithium hydroxide, sodium silicate, potassium silicate, ammonium silicate, lithium silicate, sodium tertiary phosphate, potassium tertiary phosphate, ammonium tertiary phosphate, sodium carbonate, potassium carbonate, ammonium carbonate, sodium hydrogencarbonate, potassium hydrogencarbonate, ammonium hydrogencarbonate, sodium borate, potassium borate, ammonium borate, etc., are exemplified as the inorganic alkali salts. These alkali salts may be used alone or two or more in combination.

When silicates are used as the inorganic alkali salts, a developing property can be easily regulated by the adjustment of the mixing ratio of silicon oxide SiO₂, which is the component of silicate, and alkali oxide M₂O (M represents an alkali metal or an ammonium group), and the adjustment of concentration. Of the above alkali aqueous solutions, those having the mixing ratio of silicon oxide SiO₂ and alkali oxide M₂O (SiO₂/M₂O in molar ratio) of from 0.5 to 3.0 are preferred, and from 1.0 to 2.0 are more preferred. When the SiO₂/M₂O ratio is less than 0.5, the concentration is preferably from 1 to 10 mass% of the mass of the alkali aqueous solution, more preferably from 3 to 8 mass%, and most preferably from 4 to 7 mass%. When the concentration is 1 mass% or more, developing properties and processing performances do not decrease, and when 10 mass% or more, precipitation and crystallization hardly occur, further, the solution hardly gels at the time of neutralization for discarding, so that discarding of a waste solution is carried out with ease.

For purposes of delicate adjustment of alkali concentration and assistance of solubility of a photosensitive layer, organic alkali agents may be added as auxiliary. As the organic alkali agents, e.g., monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine and tetramethylammonium hydroxide can be exemplified. These alkali agents are used alone or two or more in combination.

Surfactants can be used arbitrarily and, for example, nonionic surfactants, such as nonionic surfactants having a polyoxyalkylene ether group, polyoxyethylene alkyl esters, e.g., polyoxyethylene stearate, sorbitan alkyl esters, e.g., sorbitan monolaurate, sorbitan monostearate, sorbitan distearate, sorbitan monooleate, sorbitan sesquioleate, sorbitan trioleate, etc., and monoglyceride alkyl esters, e.g., glycerol monostearate, glycerol monooleate, etc.; anionic surfactants such as alkylbenzenesulfonates, e.g., sodium dodecylbenzenesulfonate, etc., alkylnaphthalenesulfonates, e.g., sodium butylnaphthalenesulfonate, sodium pentyl- naphthalenesulfonate, sodium hexylnaphthalenesulfonate, sodium octylnaphthalenesulfonate, etc., alkyl sulfates, e.g., sodium lauryl sulfate, etc., alkyl sulfonates, e.g., sodium dodecyl sulfonate, etc., and sulfosuccinates, e.g., sodium dilaurylsulfosuccinate, etc.; and ampholytic surfactants, such as alkylbetaines, e.g., laurylbetaine, stearylbetaine, etc., and amino acids can be exemplified. Of these surfactants, especially preferred ones are nonionic surfactants having a polyoxyalkylene ether group.

As the surfactants having a polyoxyalkylene ether group, compounds having the structure represented by the following formula (9) are preferably used.

R₄₀-O-(R₄₁-O)ₚH (9)

In formula (9), R₄₀ represents an alkyl group having from 3 to 15 carbon atoms which may have a substituent, an aromatic hydrocarbon group having from 6 to 15 carbon atoms which may have a substituent, a heterocyclic aromatic ring group having from 4 to 15 carbon atoms which may have a substituent (as the substituents, an alkyl group having from 1 to 20 carbon atoms, a halogen atom, e.g., Br, Cl, I, etc., an aromatic hydrocarbon group having from 6 to 15 carbon atoms, an aralkyl group having from 7 to 17 carbon atoms, an alkoxyl group having from 1 to 20 carbon atoms, an alkoxycarbonyl group having from 2 to 20 carbon atoms, and an acyl group having from 2 to 15 carbon atoms are exemplified), R₄₁ represents an alkylene group having from 1 to 100 carbon atoms which may have a substituent (as the substituents, an alkyl group having from 1 to 20 carbon atoms, and an aromatic hydrocarbon group having from 6 to 15 carbon atoms are exemplified), and p represents an integer of from 1 to 100.

In the above definition of formula (9), as the specific examples of "aromatic hydrocarbon groups", a phenyl group, a tolyl group, a naphthyl group, an anthryl group, a biphenyl group, a phenanthryl group, etc., are exemplified, and as the specific examples of "heterocyclic aromatic ring groups", a furyl group, a thionyl group, an oxazolyl group, an imidazolyl group, a pyranyl group, a pyridinyl group, an acridinyl group, a benzofuranyl group, a benzothionyl group, a benzopyranyl group, a benzoxazolyl group, a benzimidazolyl group, etc., are exemplified.

The moiety of (R₄₁-O)ₚ in formula (9) may comprise two or more groups in the above range. Specifically, random or block ranges of combinations of an ethyleneoxy group and a propyleneoxy group, an ethyleneoxy group and an isopropyloxy group, an ethyleneoxy group and a butyleneoxy group, and an ethyleneoxy group and an isobutyleneoxy group are exemplified. In the invention, the surfactants having a polyoxyalkylene ether group are used alone or as composite surfactants, and it is effective to use from 1 to 30 mass% in a developing solution, preferably from 2 to 20 mass%. When the addition amount is not sufficient, developability lowers, inversely too much amount results in heavy damage of development and reduction of the press life of the printing plate.

As the nonionic surfactants having a polyoxyalkylene ether group represented by formula (9), polyoxyethylene alkyl ethers, e.g., polyoxyethylene lauryl ether, polyoxyethylene cetyl ether, polyoxyethylene stearyl ether, etc., polyoxy- ethylene aryl thers, e.g., polyoxyethylene phenyl ether, polyoxyethylene naphthyl ether, etc., and polyoxyethylene alkylaryl ethers, e.g., polyoxyethylene methylphenyl ether, polyoxyethylene octylphenyl ether, polyoxyethylene nonylphenyl ether, etc., are exemplified.

These surfactants can be used alone or in combination. The content of these surfactants in a developing solution is preferably from 0.1 to 20 mass% in terms of active ingredient.

The pH of the developing solution for use in plate-making of the photosensitive lithographic printing plate in the invention is not especially restricted, but is preferably from 11.0 to 12.7, and more preferably from 11.5 to 12.5. When the pH is 11.0 or more, image formation is ensured, and when 12.7 or less, over-development can be avoided, so that the exposed area is not damaged by development.

The electric conductivity of the developing solution is preferably from 3 to 30 mS/cm. When the electric conductivity is 3 mS/cm or more, the elution of the photopolymerizable photosensitive layer on the aluminum support surface is ensured and printing is not accompanied by soiling, and when it is 30 mS/cm or less, the salt concentration does not become too high, which saves the rate of elution of the photopolymerizable photosensitive layer from becoming excessively slow, and a residual film does not occur on the unexposed area. Especially preferred electric conductivity is from 5 to 20 mS/cm.

The development of the photosensitive lithographic printing plate in the invention is carried out according to ordinary methods of, e.g., immersing the photosensitive lithographic printing plate having been subjected to exposure treatment in a developing solution at a temperature of from 0 to 60°C, preferably from 15 to 40°C or so, and rubbing with a brush.

When developing treatment is performed with an automatic processor, since the developing solution is fatigued with the processing amount, it is also effective to use a replenisher or a fresh developing solution to thereby restore processing performance.

The photosensitive lithographic printing plate thus-development treated is subjected to post treatment with water washing water, a rinsing solution containing a surfactant, and a desensitizing solution containing gum arabic and a starch derivative, as disclosed in JP-A-54-8002, JP-A-55-115045 and JP-A-59-58431. In the post treatment of the photosensitive lithographic printing plate of the invention, these treatments can be used in various combinations.

The press life of the printing plate obtained by these treatments can be improved by heating treatments, e.g., post exposure treatment and burning treatment with the methods as disclosed in JP-A-2000-89478.

The lithographic printing plate obtained by these treatments is mounted on an offset printer and used in printing of a plenty of sheets.

### EXAMPLE

The invention will be described in detail with reference to examples, but the invention is not limited thereto.

### EXAMPLES 1 TO 9

### Manufacture of support:

### (1) Support 1: An anodic oxide aluminum support

A 1S aluminum plate having a thickness of 0.30 mm was subjected to surface graining with a No. 8 nylon brush and a suspension of 800 mesh pumice stone and water, and then thoroughly washed with water. Etching was performed by the immersion of the plate in a 10 mass% sodium hydroxide aqueous solution at 70°C for 60 seconds, the plate was washed with flowing water, and then washed with a 20 mass% nitric acid aqueous solution for neutralization and followed by washing with water. On the condition of V_{A} of 12.7 V, the plate was subjected to electrolytic surface roughening treatment in a 1 mass% nitric acid aqueous solution by applying alternating waveform electric current of sine wave at anode current of 300 coulomb/dm². The surface roughness measured was 0.45 µm (Ra indication). Subsequently, the plate was immersed in a 30 mass% sulfuric acid aqueous solution and desmutting-treated at 55°C for 2 minutes. Thereafter, the plate was subjected to anodic oxidation treatment for 50 seconds in a 20 mass% sulfuric acid aqueous solution at 33°C at electric current density of 5 A/dm² by arranging a cathode on the grained surface. The amount of the anodic oxide film was 2.6 g/m². The obtained support was taken as Support 1.

### (2) Support 2: A support having an undercoat layer

Support 2 was obtained by coating the following undercoat layer coating solution containing polymer (SP1) shown below with a bar coater on the above Support 1 in a dry coating weight of 2 mg/m² and drying at 80°C for 20 seconds.

### Undercoat layer coating solution:

| | |
|---|---|
| Polymer (SP1 shown below) | 0.3 g |
| Pure water | 60.0 g |
| Methanol | 939.7 g |

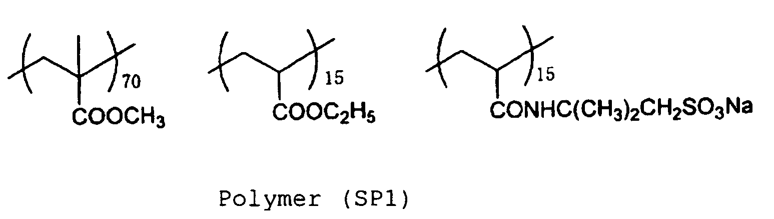

Manufacture of photopolymerizable photosensitive lithographic printing plate:

Photosensitive composition (1) having the composition shown below was coated on Support 2 with a bar coater and dried at 90°C for 1 minute, whereby a photosensitive layer was formed. The mass of the photosensitive layer after drying was 1.35 g/m².

### Photosensitive composition (1):

| | |
|---|---|
| Compound containing an ethylenic unsaturated bond (shown in Table 2) | 1.69 mass parts |
| Polymer binder (shown in Table 2) | 1.87 mass parts |
| Sensitizing dye (Exemplified Compound D40) | 0.13 mass parts |
| Hexaarylbiimidazole photopolymerization initiator (BIMD, manufactured by Kurogane Kasei Co., Ltd.) | 0.46 mass parts |
| Dispersion of ε-phthalocyanine (F-1 shown below) (a 25 mass% methyl ethyl ketone dispersion) | 1.70 mass parts |
| Sulfur-containing compound (shown in Table 2) | 0.34 mass parts |
| Fluorine-based nonionic surfactant Megafac F-780F (manufactured by Dainippon Ink and Chemicals Inc.) | 0.03 mass parts |
| Cupferron AL (a 10 mass% solution of tricresyl phosphate) (polymerization inhibitor, manufactured by Wako Pure Chemical Industries) | 0.12 mass parts |
| Methyl ethyl ketone | 27.0 mass parts |
| Propylene glycol monomethyl ether | 26.7 mass parts |

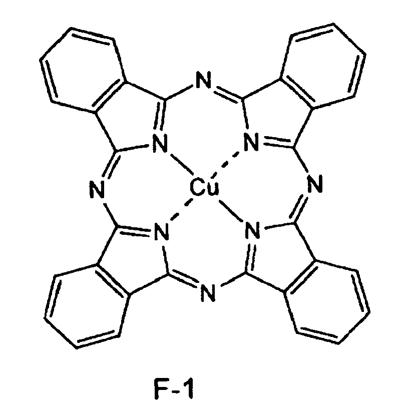

The following protective layer coating solution was coated on the photosensitive layer with a bar coater in a dry coating weight of 2.5 g/m² and dried at 120°C for 1 minute, whereby a photosensitive lithographic printing plate shown in Tale 2 below was obtained.

### Protective layer coating solution:

| | |
|---|---|
| PVA 105 (degree of saponification: 98 mol%, manufactured by Kuraray Co., Ltd.) | 6.80 mass parts |
| EMALEX 710 (nonionic surfactant, manufactured by Nippon Nyukazai Co., Ltd.) | 0.18 mass parts |
| Pionin D625 (surfactant, | 0.30 mass parts |
| manufactured by Takemoto Oil & Fat) Luviskol V64W (manufactured by BASF Japan Ltd.) | 0.50 mass parts |
| Water-soluble polymer (a 13 mass% aq. soln. of SP1) | 19.2 mass parts |
| Pure water | 139 mass parts |

### Evaluation of irregularity of plain dots:

The photosensitive lithographic printing plate was cut to a size of 700 mm x 500 mm, mounted on Violet semiconductor laser setter Vx9600 (InGaN series semiconductor laser: 405 nm ±10 nm, emission/output: 30 mW, manufactured by Fuji Film Electronic Imaging Ltd.), and 35% plain dots were imaged with FM screen, TAFFETA 20 (manufactured by Fuji Photo Film Co., Ltd.) by exposure amount of 90 µJ/cm² and resolution of 2,438 dpi. After exposure, the printing plate was automatically sent to the connected automatic processor LP1250PLX (equipped with a brush) and heated at 100°C for 10 seconds, the protective layer was removed by washing with water, subsequently the plate was developed at 28°C for 20 seconds. After development, the plate was washed with water in the rinsing bath, sent to the gumming bath, the plate after gumming was dried with hot air and discharged, whereby a lithographic printing plate having imaged plain dots was obtained. As the developing solution, developing solution DV-2 (manufactured by Fuji Photo Film Co., Ltd.) diluted with water five times was used. As the gumming solution, FP-2W (manufactured by Fuji Photo Film Co., Ltd.) diluted with water two times was used. The area ratio of the plain dots of the obtained lithographic printing plate was measured with CC-dot at 24 points with the intervals of 10 cm in the lengths and breadth directions, and the difference in area between the maximum and minimum (δ dot) was found. The results obtained are shown in Table 2 below.

### Evaluation of preservation stability:

The above photosensitive lithographic printing plate was packaged with aluminum kraft paper and heated in the oven set at 60°C for three days, after that the temperature was lowered to room temperature, and the printing plate was evaluated in the same manner as in the evaluation of irregularity of plain dots. The average value at 24 points was computed, and the difference from the time when heating at 60°C was not performed (δ dot) was computed. The results obtained are shown in Table 2 below.

### Reference EXAMPLE 10

The following photosensitive composition was coated on the same support as used in Examples 1 to 9 with a bar coater and dried at 100°C for 1 minute. The mass of the photosensitive composition after drying was 1.3 g/m².

| | |
|---|---|
| Compound (A1) containing an ethylenic unsaturated bond | 1.0 mass part |
| Exemplified polymer binder PP-3 | 1.0 mass part |
| Sensitizing dye (D29) | 0.15 mass parts |
| Photopolymerization initiator (C1) | 0.12 mass parts |
| ε-Phthalocyanine (F1) dispersion | 0.02 mass parts |
| Auxiliary sensitizer (G1) | 0.5 mass parts |
| Fluorine-based nonionic surfactant Megafac F-780F (manufactured by Dainippon Ink and Chemicals Inc.) | 0.02 mass parts |
| Methyl ethyl ketone | 26.0 mass parts |
| Propylene glycol monomethyl ether | 26.3 mass parts |

Compound containing an ethylenic unsaturated bond (A1), polymer binder (B1), photopolymerization initiator (C1), ε -phthalocyanine (F1), and auxiliary sensitizer (G1) used in the photopolymerizable photosensitive lithographic printing plate P-1 are compounds represented by the formulae shown below. As the sensitizing dye, exemplified dye (D29) was used.

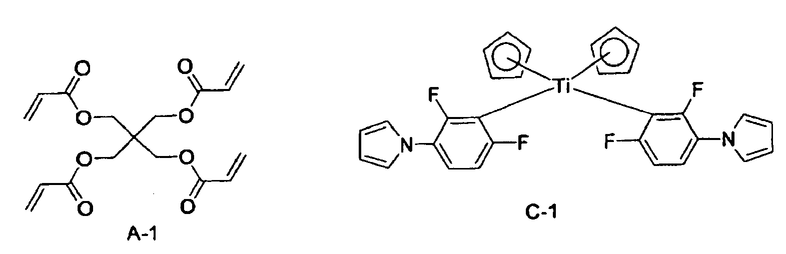

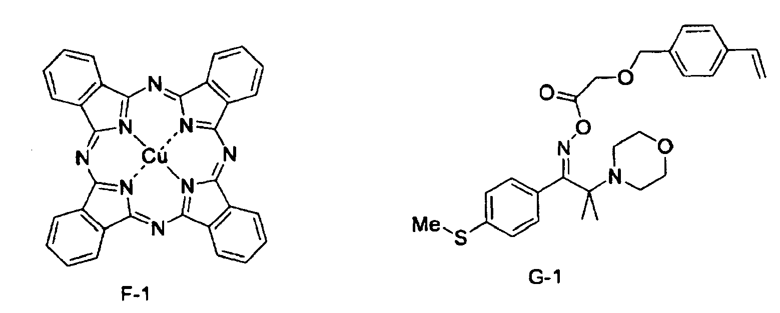

The protective layer coating solution having the composition shown below was coated on the photosensitive layer with a bar coater in a dry coating weight of 2.5 g/m² and dried at 120°C for 1 minute, whereby a photosensitive lithographic printing plate was obtained. With the obtained lithographic printing plate, plain dots and preservation stability were evaluated in the same manner as in Example 1. The results obtained are shown in Table 2.

### Protective layer coating solution:

| | |
|---|---|
| Polyvinyl alcohol (degree of saponification: 98 mol%, degree of polymerization: 500) | 5.0 mass parts |
| EMALEX 710 (nonionic surfactant, manufactured by Nippon Nyukazai Co.) | 0.09 mass parts |
| Pure water | 94.91 mass parts |

### EXAMPLE 11

A photosensitive lithographic printing plate was prepared in the same manner as in Example 10 with the same support and the photosensitive layer coating solution, except that the protective layer coating solution used in Examples 1 to 9 was used. With the obtained lithographic printing plate, plain dots and preservation stability were evaluated in the same manner as in Example 1. The results obtained are shown in Table 2.

### COMPARATIVE EXAMPLE 1

Photosensitive composition (2) having the composition shown below was coated on the same support as used in Examples 1 to 9 with a bar coater and dried at 100°C for 1 minute. The mass of the photosensitive composition after drying was 1.3 g/m².

### Photosensitive composition (2):

| | |
|---|---|
| Compound containing an ethylenic unsaturated bond (A1 shown below) | 1.0 mass part |
| Polymer binder (copolymer of methacrylic acid and allyl methacrylate, molar ratio: 15/85, mass average molecular weight: 80,000) | 1.0 mass part |
| Sensitizing dye (Exemplified Compound D29) | 0.15 mass parts |
| Photopolymerization initiator (C1 shown below) | 0.12 mass parts |
| ε-Phthalocyanine dispersion (F1) | 0.02 mass parts |
| Auxiliary sensitizer (G1 shown below) | 0.5 mass parts |
| Fluorine-based nonionic surfactant Megafac F-780F (manufactured by Dainippon Ink and Chemicals Inc.) | 0.02 mass parts |
| Methyl ethyl ketone | 26.0 mass parts |
| Propylene glycol monomethyl ether | 26.3 mass parts |

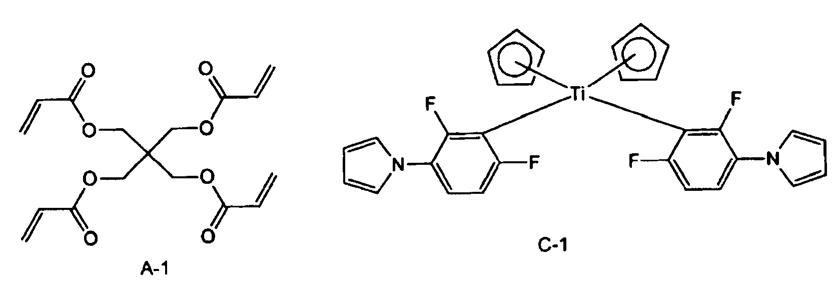

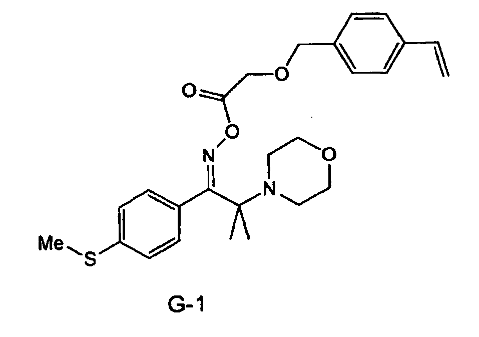

Protective layer coating solution (2) having the composition shown below was coated on the photosensitive layer with a bar coater in a dry coating weight of 2.5 g/m² and dried at 120°C for 1 minute, whereby a photosensitive lithographic printing plate was obtained. With the obtained lithographic printing plate, plain dots and preservation stability were evaluated in the same manner as in Example 1. The results obtained are shown in Table 2. Protective layer coating solution (2):

| | |
|---|---|
| Polyvinyl alcohol (degree of saponification: 98 mol%, degree of polymerization: 500) | 5.0 mass parts |
| EMALEX 710 (nonionic surfactant, manufactured by Nippon Nyukazai Co., Ltd.) | 0.09 mass parts |
| Pure water | 94.91 mass parts |

**TABLE 2**

| Example No. | Binder Polymer | Monomer | Sulfur-Containing Compound | Evaluation of Plain Dot Irregularity (δ dot) | Preservation Stability (δ dot) |
|---|---|---|---|---|---|
| Example 1 | PP-3 | U6ELH | SH-5 | 1.5 | 2.0 |
| Example 2 | PP-4 | PLEX6661-O | SH-5 | 2.0 | 2.5 |
| Example 3 | PP-4 | PLEX6661-O | SH-8 | 2.0 | 1.5 |
| Example 4 | PP-4 | U6ELH | SH-8 | 2.5 | 1.5 |
| Example 5 | PP-4 | U6ELH | SH-1 | 1.5 | 2.5 |
| Example 6 | PP-4 | PLEX6661-O | SH-1 | 2.5 | 1.0 |
| Example 7 | PP-3 | PLEX6661-O | SH-1 | 2.5 | 2.5 |
| Example 8 | PP-4 | PLEX6661-O | SH-5 | 2.0 | 2.0 |
| Example 9 | PP-3 | PLEX6661-O | SH-8 | 2.5 | 1.5 |
| Reference Example 10 | PP-3 | A-1 | None | 4.0 | 3.5 |
| Example 11 | PP-3 | A-1 | None | 3.0 | 3.5 |
| Comparative Example 1 | (*1) | A-1 | None | 6.5 | 5.0 |

| | | | | | |
|---|---|---|---|---|---|
| (*1): Copolymer of methacrylic acid and allyl methacrylate PP-3: The ratio of repeating units (1)/(a)/(b) = 10/14/76 Mass average molecular weight: 80,000 PP-4 The ratio of repeating units (1)/(a)/(b) = 10/14/76 Mass average molecular weight: 80,000 | | | | | |

It is clearly seen from the results shown in Table 2 that the photosensitive lithographic printing plates in the invention are excellent in the evaluations of irregularity of plain dots using FM screen and preservation stability as compared with the conventional photosensitive lithographic printing plate

### (Comparative Example 1).

The invention provides a lithographic printing plate suitable for imaging with laser beams, good in preservation stability, and good in half tone plain dot uniformity using highly precise AM screen printing of screen line number of 200 lines or more and FM screen printing, in particular, FM screen.

## Claims

1. A negative type photopolymerizable photosensitive lithographic printing plate, which is capable of image-recording with laser beams, comprising, in order:
a hydrophilic support;
at least one photopolymerizable photosensitive layer; and
a protective layer comprising a water-soluble polymer containing a polyvinyl alcohol having a saponification degree of 95 mol% or more, and a water-soluble polymer containing sulfonic acid groups or an alkali metal salt or an ammonium salt of sulfonic acid groups,
wherein the at least one photosensitive layer comprises:
(i) a sensitizing dye having an absorption maximum in a wavelength region of from 360 to 450 nm;
(ii) a photopolymerization initiator;
(iii) an addition polymerizable compound having an ethylenic unsaturated double bond; and
(iv) a binder polymer that comprises at least one repeating unit represented by formula (1): 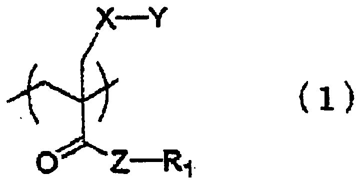 wherein X represent an oxygen atom, a sulfur atom or an -NH- group;
Y represents a hydrogen atom or a hydrocarbon group having from 1 to 20 carbon atoms which may have a substituent;
Z represents an oxygen atom, a sulfur atom or an -NH-group; and
R₁ represents a hydrocarbon group having from 1 to 20 carbon atoms which may have a substituent.

2. The negative type photopolymerizable photosensitive lithographic printing plate according to claim 1,
wherein (ii) the photopolymerization initiator is a hexaarylbisimidazole compound.

3. The negative type photopolymerizable photosensitive lithographic printing plate according to claim 2,
wherein (ii) the photopolymerization initiator further comprises a sulfur-containing compound represented by formula (2) or (3): 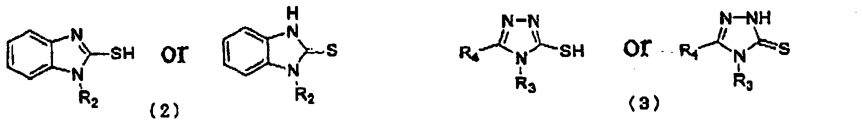 wherein R₂, R₃ and R₄ each independently represents a hydrogen atom, a straight chain or branched alkyl group having from 1 to 18 carbon atoms which may have a substituent, an alicyclic alkyl group having from 5 to 20 carbon atoms or an aromatic group.

4. The negative type photopolymerizable photosensitive lithographic printing plate according to claim 1,
wherein the sensitizing dye is a dye represented by formula (4), (5), (6) or (7): 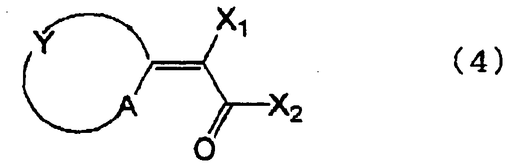 wherein A represents a sulfur atom or NR₆;
R₆ represents a monovalent nonmetallic atomic group;
Y represents a nonmetallic atomic group to form a basic nucleus of the dye conjointly with the contiguous A and the contiguous carbon atom; and
X₁ and X₂ each independently represents a monovalent nonmetallic atomic group, and X₁ and X₂ may be bonded to each other to form an acidic nucleus of the dye, 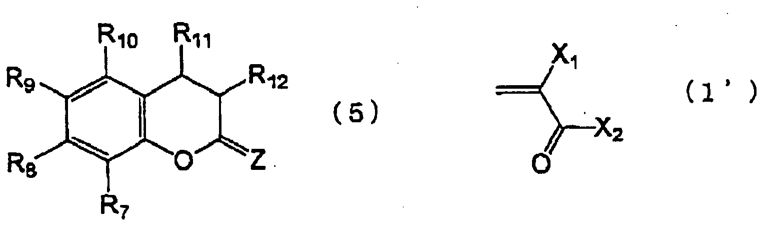 wherein = Z represents a carbonyl group, a thiocarbonyl group, an imino group or an alkylidene group represented by partial structural formula (1');
X₁ and X₂ have the same meaning as in formula (4); and
R₇ to R₁₂ each independently represents a monovalent nonmetallic atomic group, 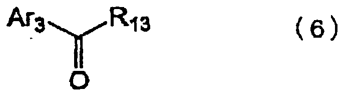 wherein Ar₃ represents an aromatic group or a heteroaromatic group, each of which may have a substituent; and
R₁₃ represents a monovalent nonmetallic atomic group, or 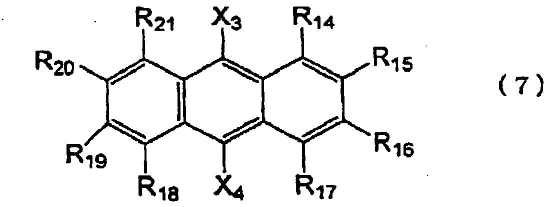 wherein X₃, X₄, R₁₄ to R₂₁ each independently represents a monovalent nonmetallic atomic group.

5. The negative type photopolymerizable photosensitive lithographic printing plate according to claim 4,
wherein the sensitizing dye is a dye represented by formula (8) : 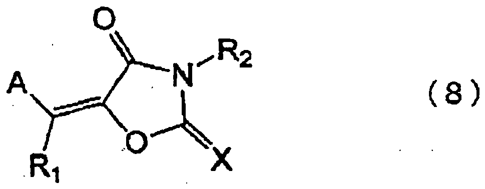 wherein A represents an aromatic ring or a heterocyclic ring that may have a substituent;
X represents an oxygen atom, a sulfur atom or NR₃;
R₁, R₂ and R₃ each independently represents a hydrogen atom or a monovalent nonmetallic atomic group, and A and R₁, and R₂ and R₃ may be bonded to each other to form an aliphatic or aromatic ring.

6. The negative type photopolymerizable photosensitive lithographic printing plate according to claim 1,
wherein the binder polymer further comprises: (a) a repeating unit for imparting alkali solubility; and (b) a repeating unit for imparting a radical crosslinking property.

## Patentansprüche

1. Fotopolymerisierbare, fotoempfindliche Lithograpfiedruckplatte vom Negativtyp, die zur Bildaufzeichnung mit Laserstrahlen befähigt ist, umfassend in Reihenfolge:
einen hydrophilen Träger,
mindestens eine fotopolymerisierbare, fotoempfindliche Schicht, und
eine Schutzschicht, umfassend ein wasserlösliches Polymer, das einen Polyvinylalkohol mit einem Verseifungsgrad von 95 mol% oder mehr enthält, und ein wasserlösliches Polymer, das Sulfonsäuregruppen oder ein Alkalimetallsalz oder ein Ammoniumsalz von Sulfonsäuregruppen enthält,
worin die mindestens eine fotoempfindliche Schicht umfasst:
(i) einen Sensibilisierungsfarbstoff mit einem Absorptionsmaximum im Wellenlängenbereich von 360 bis 450 nm;
(ii) einen Fotopolymerisationsinitiator;
(iii) eine additionspolymerisierbare Verbindung mit einer ethylenisch ungesättigten Doppelbindung; und
(iv) ein Binderpolymer, das mindestens eine durch die Formel (1) dargestellte Wiederholungseinheit umfasst: 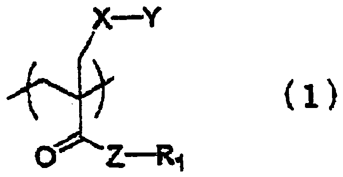 worin X ein Sauerstoffatom, ein Schwefelatom oder eine -NH-Gruppe darstellt;
Y ein Wasserstoffatom oder eine Kohlenwasserstoffgruppe mit 1 bis 20 Kohlenstoffatomen darstellt, die einen Substituenten aufweisen kann;
Z ein Sauerstoffatom, ein Schwefelatom oder eine -NH-Gruppe darstellt; und
R₁ eine Kohlenwasserstoffgruppe mit 1 bis 20 Kohlenstoffatomen darstellt, die einen Substituenten aufweisen kann.

2. Fotopolymerisierbare, fotoempfindliche Lithograpfiedruckplatte vom Negativtyp gemäß Anspruch 1,
worin (ii) der Fotopolymerisationsinitiator eine Hexaarylbisimidazolverbindung ist.

3. Fotopolymerisierbare, fotoempfindliche Lithograpfiedruckplatte vom Negativtyp gemäß Anspruch 2,
worin (ii) der Fotopolymerisationsinitiator ferner eine schwefelhaltige Verbindung umfasst, dargestellt durch die Formel (2) oder (3): 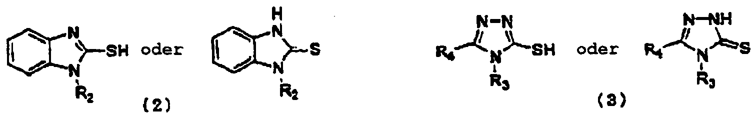 worin R₂, R₃ und R₄ jeweils unabhängig ein Wasserstoffatom, eine geradkettige oder verzweigte Alkylgruppe mit 1 bis 18 Kohlenstoffatomen, die einen Substituenten aufweisen kann, eine alicyclische Alkylgruppe mit 5 bis 20 Kohlenstoffatomen oder eine aromatische Gruppe darstellen.

4. Fotopolymerisierbare, fotoempfindliche Lithografieplatte vom Negativtyp gemäß Anspruch 1, worin der Sensibilisierungsfarbstoff ein durch die Formel (4), (5), (6) oder (7) dargestellter Farbstoff ist: 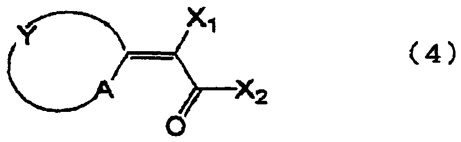 worin A ein Schwefelatom oder NR₆ darstellt;
R₆ eine monovalente, nicht-metallische Atomgruppe darstellt;
Y eine nicht-metallische Atomgruppe zum Bilden eines basischen Kerns des Farbstoffs zusammen mit dem benachbarten A und dem benachbarten Kohlenstoffatom darstellt; und
X₁ und X₂ jeweils unabhängig eine monovalente nicht-metallische Atomgrupe darstellen und X₁ und X₂ miteinander verbunden sein können, um einen sauren Kern des Farbstoffs zu bilden, 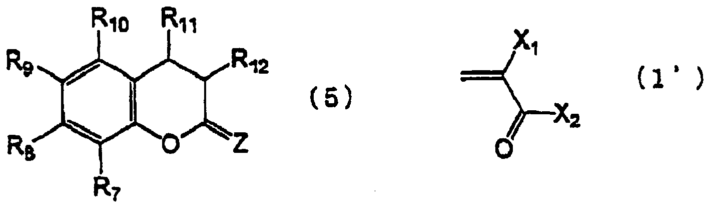 worin =Z eine Carbonylgruppe, eine Thiocarbonylgruppe, eine Iminogruppe oder eine Alkylidengruppe, dargestellt durch die Teilstrukturformel (1'), darstellt;
X₁ und X₂ die gleichen Bedeutungen wie in Formel (4) besitzen; und
R₇ bis R₁₂ jeweils unabhängig eine monovalente, nicht-metallische Atomgruppe darstellen, 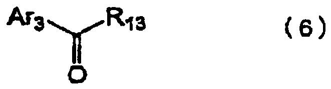 worin Ar₃ eine aromatische Gruppe oder eine heteroaromatische Gruppe darstellt, von denen jede einen Substituenten aufweisen kann; und
R₁₃ eine monovalente, nicht-metallische Atomgruppe darstellt, oder 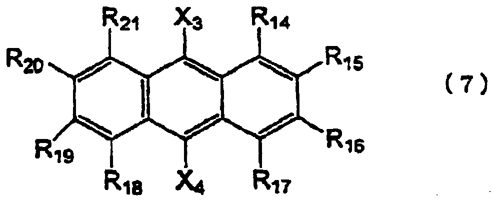 worin X₃, X₄, R₁₄ bis R₂₁ jeweils unabhängig eine monovalente, nicht-metallische Atomgruppe darstellen.

5. Fotopolymerisierbare, fotoempfindliche Lithografieplatte vom Negativtyp gemäß Anspruch 4,
worin der Sensibilisierungsfarbstoff ein durch die Formel (8) dargestellter Farbstoff ist: 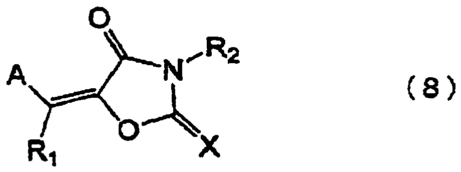 worin A einen aromatischen Ring oder einen heterocyclischen Ring, die einen Substituenten aufweisen können, darstellt;
X ein Sauerstoffatom, ein Schwefelatom oder NR₃ darstellt;
R₁, R₂ und R₃ jeweils unabhängig voneinander ein Wasserstoffatom oder eine monovalente, nicht-metallische Atomgruppe darstellen, und A und R₁, und R₂ und R₃ miteinander verbunden sein können, um einen aliphatischen oder aromatischen Ring zu bilden.

6. Fotopolymerisierbare, fotoempfindliche Lithografieplatte vom Negativtyp gemäß Anspruch 1,
worin das Binderpolymer ferner umfasst: (a) eine Wiederholungseinheit zum Verleihen von Alkali-Löslichkeit; und (b) eine Wiederholungseinheit zum Verleihen einer Radikal-Vernetzungseigenschaft.

## Revendications

1. Plaque d'impression lithographique photosensible de type négatif pouvant être photopolymérisée, qui est susceptible d'un enregistrement d'image avec des faisceaux laser, comprenant, dans l'ordre :
un support hydrophile ;
au moins une couche photosensible pouvant être photopolymérisée ; et
une couche protectrice comprenant un polymère hydrosoluble contenant un alcool de polyvinyle ayant un degré de saponification de 95 % en mole ou plus, et un polymère hydrosoluble contenant des groupes acide sulfonique ou un sel de métal alcalin ou un sel d'ammonium de groupes acide sulfonique,
dans laquelle l'au moins une couche photosensible comprend :
(i) une teinture sensibilisante ayant un maximum d'absorption dans une zone de longueurs d'onde de 360 à 450 nm ;
(ii) un initiateur de photopolymérisation ;
(iii) un composé pouvant être polymérisé par addition ayant une liaison double non saturée en ce qui concerne l'éthylène ; et
(iv) un polymère liant qui comprend au moins une unité de répétition représentée par la formule (1) : 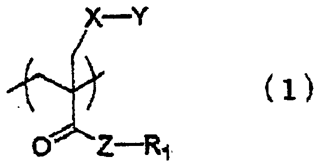 dans laquelle X représente un atome d'oxygène, un atome de soufre ou un groupe -NH- ;
Y représente un atome d'hydrogène ou un groupe hydrocarbure ayant de 1 à 20 atomes de carbone qui peuvent avoir un substituant ;
Z représente un atome d'oxygène, un atome de soufre ou un groupe -NH- ; et
R₁ représente un groupe hydrocarbure ayant de 1 à 20 atomes de carbone qui peuvent avoir un substituant.

2. Plaque d'impression lithographique photosensible de type négatif pouvant être photopolymérisée selon la revendication 1,
dans laquelle (ii) l'initiateur de photopolymérisation est un composé d'hexa-aryl-bis-imidazole.

3. Plaque d'impression lithographique photosensible de type négatif pouvant être photopolymérisée selon la revendication 2,
dans laquelle (ii) l'initiateur de photopolymérisation comprend en outre un composé contenant du soufre représenté par la formule (2) ou (3) : 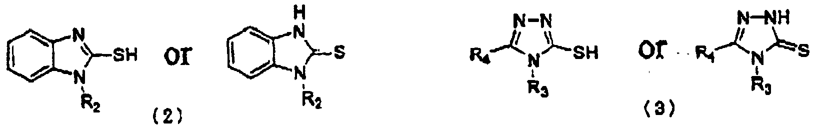 dans lesquelles R₂, R₃ et R₄ représentent chacun indépendamment un atome d'hydrogène, un groupe alkyle ramifié ou à chaîne droite ayant de 1 à 18 atomes de carbone qui peuvent avoir un substituant, un groupe alkyle alicyclique ayant de 5 à 20 atomes de carbone ou un groupe aromatique.

4. Plaque d'impression lithographique photosensible de type négatif pouvant être photopolymérisée selon la revendication 1,
dans laquelle la teinture sensibilisante est une teinture représentée par la formule (4), (5), (6) ou (7) : 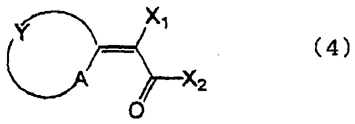 dans lesquelles A représente un atome de soufre ou NR₆ ;
R₆ représente un groupe atomique non métallique monovalent ;
Y représente un groupe atomique non métallique pour former un noyau de base de la teinture conjointement avec le A contigu et l'atome de carbone contigu ; et
X₁ et X₂ représentent chacun indépendamment un groupe atomique non métallique monovalent, et X₁ et X₂ peuvent être liés l'un à l'autre pour former un noyau acide de la teinture, 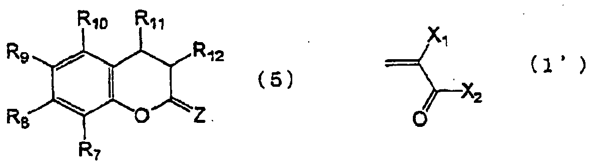 dans lesquelles =Z représente un groupe carbonyle, un groupe thiocarbonyle, un groupe imino ou un groupe alkylidène représenté par la formule structurelle partielle (1') ;
X₁ et X₂ ont la même signification que dans la formule (4) ; et
R₇ à R₁₂ représentent chacun indépendamment un groupe atomique non métallique monovalent, 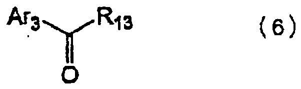 dans laquelle Ar₃ représente un groupe aromatique ou un groupe hétéroaromatique, chacun d'eux pouvant avoir un substituant ; et
R₁₃ représente un groupe atomique non métallique monovalent, ou 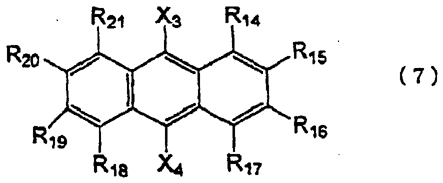 dans laquelle X₃, X₄, R₁₄ à R₂₁ représentent chacun indépendamment un groupe atomique non métallique monovalent.

5. Plaque d'impression lithographique photosensible de type négatif pouvant être photopolymérisée selon la revendication 4,
dans laquelle la teinture sensibilisante est une teinture représentée par la formule (8) : 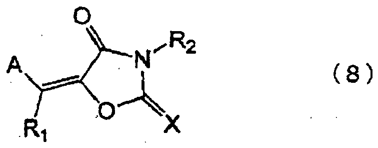 dans laquelle A représente un noyau aromatique ou un anneau hétérocyclique qui peut avoir un substituant ;
X représente un atome d'oxygène, un atome de soufre ou NR₃ ;
R₁, R₂ et R₃ représentent chacun indépendamment un atome d'hydrogène ou un groupe atomique non métallique monovalent, et A et R₁, et R₂ et R₃ peuvent être liés l'un à l'autre pour former un noyau aliphatique ou aromatique.

6. Plaque d'impression lithographique photosensible de type négatif pouvant être photopolymérisée selon la revendication 1,
dans laquelle le polymère liant comprend en outre : (a) une unité de répétition pour communiquer une solubilité alcaline ; et (b) une unité de répétition pour communiquer une propriété de réticulation par radicaux.
